# EUROPÄISCHE PATENTSCHRIFT

(11) **EP 3 621 203 B1**
(45) Veröffentlichungstag und Bekanntmachung des Hinweises auf die Patenterteilung: **13.07.2022**
(21) Anmeldenummer: 19195908.9
(22) Anmeldetag: 06.09.2019
(51) Int. Cl.: H03K 17/955, G06F 3/044, H03K 17/96

(54) **BEDIENEINHEIT FÜR EINEN EINSATZ UNTER WASSER UND VERFAHREN ZU IHRER HERSTELLUNG**
OPERATING UNIT FOR USE IN WATER AND METHOD FOR PRODUCING THE SAME
UNITÉ DE COMMANDE POUR UNE UTILISATION SOUS L'EAU ET SON PROCÉDÉ DE FABRICATION

(30) Priorität: 07.09.2018 DE 102018121932
(43) Veröffentlichungstag der Anmeldung: 11.03.2020
(73) Patentinhaber: Irlbacher Blickpunkt Glas GmbH, 92539 Schönsee (DE)
(72) Erfinder: Irlbacher, Günther, 92539 Schönsee (DE)
(74) Vertreter: Hinkelmann, Klaus

(56) Entgegenhaltungen:
- WO-A1-2015/088453
- WO-A1-2018/065587
- DE-A1-102012 207 114
- DE-A1-102013 215 060
- US-A1- 2016 334 935

## Beschreibung

Die Erfindung betrifft eine Bedieneinheit für einen Einsatz unter Wasser und ein Verfahren zu ihrer Herstellung. Die Erfindung betrifft insbesondere eine Bedieneinheit für einen Einsatz unter Wasser, mit einer Frontplatte aus Glas und elektrischen und/oder mechanischen Sensorelementen, die auf einer Sensorplatte angeordnet sein können, und einer Steuerungseinheit, wobei auf der Frontplatte und/oder einer Sensorplatte eine eingebrannte keramische Leitpaste aufgebracht ist, sowie ein bevorzugtes Verfahren zu deren Herstellung.

Bedieneinheiten, insbesondere sogenannte Touchscreens werden immer häufiger in verschiedenen Bereichen eingesetzt, wie zum Beispiel als Bedienpanel zur Steuerung von Haushaltsgeräten, Maschinen und Anlagen, bei Elektrokleingeräten wie Computern, Telefonen und ähnlichem. Insbesondere wurden in den letzten Jahren zunehmend Bedieneinheiten der "Projected Capacitive Touch" (PCT)-Technologie eingesetzt, bei der die Touch-Erkennung durch eine Schutzscheibe vor einem Display ermöglicht wird. Solche PCT-Touchscreens können wetterbeständig ausgebildet sein, wodurch sie insbesondere auch im Außenbereich eingesetzt werden können. Solche Bedieneinheiten wurden allerdings bislang nicht unter Wasser eingesetzt, da die Auswertung von Berührungen unter Wasser als sehr schwierig angesehen wurde. Daher sind auch keine Bedieneinheiten für den Betrieb unter Wasser bekannt, die beispielsweise in einem Schwimmbecken über die Berührung und oder Annäherung einer Person an die Bedieneinheit die Ausführung verschiedener Aktionen veranlassen können.

Die Veröffentlichung "Touché: Enhancing Touch Interaction on Humans, Screens, Liquids, and Everyday Objects" von Munehiko Sato, Ivan Poupyrev, Chris Harrison (vgl.: https://www.disneyresearch.com/publication/touche-enhancing-touch-interaction-on-humans-screens-liquids-and-everyday-objects/) befasst sich mit der Erkennung von Berührungen auf einer Bedienungseinheit unter Wasser. Kern der darin beschriebenen Technik ist eine neue "Swept Frequency Capacitive Sensing Technique", die darauf beruht, dass ein Frequenzspektrum durchfahren wird. Dadurch soll nicht nur die Detektion einer Berührung möglich sein, sondern auch die Erkennung von komplexen Konfigurationen der menschlichen Hände und des menschlichen Körpers. Dabei können ein oder mehr Sensorelektroden verwendet werden. Im Artikel wird herausgestellt, dass in einem typischen Berührungssensor ein leitfähiges Objekt durch ein elektrisches Signal fester Frequenz angeregt wird, dies aber Nachteile hat. Was Wasser anbelangt, so erwähnt dieser Artikel lediglich, dass mittels des Sensors festgestellt werden kann, ob jemand z.B. Wasser berührt bzw. in Wasser eintaucht. Im Abschnitt "Sensing Gestures in Liquids" wird herausgestellt, dass Interagieren mit Wasser nicht die Benutzung von Touchscreens unter Wasser bedeutet, sondern die Berührung von Wasser selbst.

Die Veröffentlichung US 2012/0256867 A1 beschreibt ein Unterwasser-Touchscreen-System, umfassend eine Umhüllung, die einen internen Raum und eine Fensterfläche beinhaltet; eine digitale Vorrichtung, die ein kapazitives Touchscreen-Display enthält, welches innerhalb des internen Raumes der Umhüllung angeordnet ist, wobei der kapazitive Touchscreen-Display in Nachbarschaft zur Fensterfläche der Umhüllung ist. Es ist zusätzlich eine innere Membran und eine äußere Membran beschrieben. Es wird überdies eine Flüssigkeit mit einer vergleichsweise niedrigen dielektrischen Konstante verwendet, um für die Auswertung von kapazitiven Signalen nachteilige Effekte des Wassers auszugleichen.

Die Veröffentlichung DE 100 11 229 B4 beschreibt einen kapazitiven Berührungssensor, der vor allem im Sanitärbereich sinnvoll eingesetzt werden kann. Es wird auf die besonderen Schwierigkeiten bei der Verwendung von kapazitiven Sensoren im Kontakt mit Wasser eingegangen. Danach sollen derartige kapazitive Sensoren sehr störanfällig gegenüber elektrostatischen Entladungen, elektromagnetischer Einstrahlung und äußerst empfindlich gegenüber Änderungen der Dielektrizitätskonstanten in umgebenden Medien, z.B. durch Feuchtigkeit, Benetzung, Wasserdampf sein, weshalb sie insbesondere im Sanitärarmaturenbereich auch bei Vorsehen einer entsprechend komplexen Steuerungselektronik nur bedingt einsetzbar sein sollen. Im Übrigen geht diese Veröffentlichung auf die genaue elektronische Ausgestaltung dieses Berührungssensors ein. Dies illustriert, dass ein Fachmann davon abgehalten wird, beispielsweise kapazitive Sensorik im Unterwasserbereich einzusetzen.

Die Veröffentlichung WO 2017/167818 A1 befasst sich mit der Robustheit in Wasser von kapazitiven Sensoren sowie der Detektion von Berührungen, wobei insbesondere die Funktionsweise des verwendeten Prozessors in einigem Detail beschrieben wird.

Bei Bedieneinheiten befinden sich üblicherweise die Sensorelektroden auf einem Sensorsubstrat, beispielsweise aus Glas oder Kunststoff. Dabei ermöglicht ein Glassubstrat durch seine Transparenz nicht nur die Anordnung vor einem Display, sondern erfüllt auch durch seine dielektrischen Eigenschaften alle Anforderungen, die an Leiterplatten für elektronische Schaltungen mit hoher Integrationsdichte und Höchstfrequenzen gestellt werden.

Außerdem beinhalten insbesondere PCT-Bedieneinheiten häufig voneinander getrennte Sensorschichten für die Detektion einerseits in Richtung einer X-Achse und für die Detektion andererseits in Richtung einer Y-Achse, wodurch die Berührungsposition nicht nur auf kleinen vordefinierten Sensorfeldern, sondern über den gesamten Bereich bestimmbar ist. Diese Sensorschicht ist zumeist durch eine Indium-Zinn-Oxid(ITO)-Beschichtung gebildet, die entsprechend in X- oder Y-Richtung strukturiert wird. Zusätzlich werden dann je nach Layout weitere metallische Leitstrukturen wie z.B. Leiterbahnen und Widerstände angeordnet.

So offenbart die EP 2 439 622 A1 ein Bedien- und Beobachtungsgerät mit zwei berührungssensitiven Sensoren, das derart ausgebildet sein kann, dass zwei Glasscheiben miteinander über Abstandshalter verbunden sind und an den einander zugewandten Oberflächen mit ITO beschichtet sind. Die mit ihrer nicht mit ITO beschichteten Seite dem Benutzer zugewandte Glasscheibe kann beispielsweise als Dünnglasscheibe ausgestaltet sein, wobei die auf der Dünnglasscheibe angebrachte ITO-Schicht sowohl als Sensor für den kapazitiven Touch-Sensor als auch als eine Schicht des resistiven Touch-Sensors dient.

Hierbei ist es jedoch nachteilig, dass die Strukturierung der metallischen Leitstrukturen mittels Dünnschichttechnik bzw. mittels Photolithographie in der Regel Vakuum erfordert und dementsprechend aufwendig und teuer ist.

Die Veröffentlichung DE 10 2013 215 060 A1 beschreibt eine kapazitive Sensorvorrichtung mit u.a. einer Frontplatte aus Glas und einer elektrisch leitfähig beschichteten Sensorplatte aus Dünnglas, wobei auf der Sensorplatte eine keramische Leitstruktur aus einer eingebrannten keramischen Leitpaste angeordnet ist. Die kapazitive Sensorvorrichtung soll die Möglichkeit einer breiten Anwendbarkeit mit einer einfachen und kostengünstigen Herstellung vereinen und soll in vielen Bereichen eingesetzt werden können, beispielsweise für Sensorvorrichtungen mit PCT-Technologie, für Außenanwendungen oder für sonstige Bereiche, in denen robuste Ausführungen gefordert sind. Durch den Einsatz einer Dünnglasscheibe als Sensorplatte werden im Gesamtaufbau sehr dünne Sensorvorrichtungen ermöglicht, die zudem ein geringeres Gewicht aufweisen. Gleichzeitig soll die Verwendung einer eingebrannten keramischen Leitpaste zur Ausbildung der Leitstrukturen eine hervorragende Anhaftung der Leitstrukturen an das Dünnglassubstrat sowie eine hohe Beständigkeit gegenüber Umwelteinflüssen, UV-Strahlung und chemischen Einflüssen gewähren.

Die Veröffentlichung US 2016/0334935 A1 offenbart eine Betriebsmethode für eine elektronische Vorrichtung, welche umfasst: Bestimmung, ob eine Umgebung eines Touchscreenpanels sich von einer ersten Umgebung hin zu einer zweiten Umgebung geändert hat; und wenn dass der Fall ist, Ändern einer Referenzspannung des Touchscreenpanels von einem ersten zu einem zweiten Wert. In einer Ausführungsform ist die erste Umgebung eine Umgebung in Luft und die zweite Umgebung eine Umgebung im Wasser. Betriebsmethode und elektronische Vorrichtung sind beispielsweise in Fig. 7 und Fig. 9 der US 2016/0334935 A1 gezeigt.

Aufgabe der Erfindung war es vor diesem Hintergrund, eine Bedieneinheit für eine Einsatz unter Wasser bereitzustellen, deren Aufbau eine große Beständigkeit und somit einen großen Einsatzbereich ermöglicht und die gleichzeitig einfach und kostengünstig herzustellen ist. Aufgabe der Erfindung war außerdem die Bereitstellung eines Verfahrens zur Herstellung einer solchen Bedieneinheit.

Die Lösung dieser Aufgabe wird nach dieser Erfindung erreicht durch eine Bedieneinheit sowie ein Verfahren zu ihrer Herstellung mit den Merkmalen der entsprechenden unabhängigen Patentansprüche. Bevorzugte Ausführungsformen der erfindungsgemäßen Bedieneinheit sind in entsprechenden abhängigen Patentansprüchen aufgeführt. Bevorzugten Ausführungsformen der erfindungsgemäßen Bedieneinheit entsprechen bevorzugte Ausführungsformen des erfindungsgemäßen Verfahrens und umgekehrt, selbst wenn dies hierin nicht explizit festgestellt wird.

Gegenstand der Erfindung ist somit eine Bedieneinheit für einen Einsatz unter Wasser, mit einer Frontplatte aus Glas und elektrischen Sensorelementen, die auf einer Auswertung von Änderungen der elektrischen Kapazität basieren, und einer Steuerungseinheit, wobei die Sensorelemente auf einer einem Inneren der Bedieneinheit zugewandten ersten Oberfläche der Frontplatte und/oder auf einer Sensorplatte platziert sind, wobei auf der Frontplatte und/oder der Sensorplatte, auf der Sensorelemente platziert sind, eine keramische Leitstruktur aus einer eingebrannten keramischen Leitpaste angeordnet ist; wobei ein Sensorelement durch eine strukturierte elektrisch leitfähige Beschichtung gebildet wird, wobei die strukturierte elektrisch leitfähige Beschichtung mit der keramischen Leitstruktur elektrisch leitfähig verbunden ist, und wobei die Bedieneinheit mindestens zwei Sensorelemente umfasst, die unabhängig voneinander als Sensortaste und/oder Slider ausgestaltet sind, die mit einem Mikrocontroller verbunden sind, wobei Sensortaste oder Slider auf eine Berührung oder Annäherung durch einen Menschen an die Bedieneinheit mit einer Änderung einer Kapazität reagieren und die Steuerungseinheit ausgestaltet ist, um aus dem Ausmaß der Änderung der Kapazität sowie deren zeitlicher Änderung bei mindestens zwei Sensorelementen auf eine Berührung oder Annäherung eines Menschen zu schließen und außerdem zu erkennen, ob sich die kapazitive Bedieneinheit im Kontakt mit Wasser oder außerhalb von Wasser befindet, und als Reaktion auf die Berührung oder Annäherung eine Aktion auszulösen, wenn sich die Bedieneinheit unter Wasser befindet, und wobei die Bedieneinheit ein IR-Sensorsystem und/oder einen Helligkeitssensor umfasst.

An dieser Stelle sei darauf hingewiesen, dass die Formulierung "für einen Einsatz unter Wasser" insbesondere auch bedeutet, dass die Erfindung insbesondere auch die Verwendung der hierin beschriebenen Bedieneinheit für einen Einsatz unter Wasser einschließt.

Der Begriff "Feststellung von Berührungen und Annäherungen einer Person an die Bedieneinheit" ist hierin breit auszulegen. Insbesondere umfasst Annäherungen einer Person auch eine einfache Annäherung einer Person oder auch die Ausführung von Gesten durch eine Person vor der Bedieneinheit, insbesondere in einem Abstand kleiner als 50 cm, mehr bevorzugt kleiner als 20 cm, vor der Bedieneinheit, wobei verschiedene Gesten für verschiedene Eingaben stehen können.

Der Begriff "Einsatz unter Wasser" ist breit zu verstehen. Beispiele für Anwendungen der Bedieneinheit sind beispielsweise ein Schwimmbecken, sei es in einem Hallen- oder Freibad, oder ein großes Aquarium, in dem sich auch Taucher bzw. Tierpfleger bewegen. Daher ist ein Einsatz in Salzwasser oder in Süßwasser möglich, wobei dieses auch Luftblasen (wie z.B. in einem Whirlpool) enthalten kann, also mit Luftblasen durchsetzt sein kann. Das Wasser kann auch leicht verschmutzt oder trübe sein.

In der erfindungsgemäßen Bedieneinheit ist auf der Frontplatte und/oder einer Sensorplatte eine strukturierte, im Wesentlichen transparente, elektrisch leitfähige Schicht angeordnet. Bei dieser Bedieneinheit sind Sensorelemente auf der Frontplatte und/oder einer Sensorplatte platziert, wobei auf der Frontplatte und/oder der Sensorplatte, auf der Sensorelemente platziert sind, eine keramische Leitstruktur aus einer eingebrannten keramischen Leitpaste angeordnet ist.

Vorzugsweise enthält in der Bedieneinheit die eingebrannte keramische Leitpaste mindestens 50 Gew.-% Silber.

Erfindungsgemäß bevorzugt ist eine Bedieneinheit, bei der mindestens ein Sensorelement auf der Frontplatte angeordnet ist.

In einer erfindungsgemäß besonders bevorzugten Ausführungsform der Bedieneinheit ist die Frontplatte so ausgestaltet, dass sich mindestens eine der Stellen, an denen sich auf oder hinter der Frontplatte ein Sensorelement befindet, haptisch von der Umgebung dieser Stelle unterscheidet. Diese Stelle, beispielsweise in Form eines Kreises, einer Ellipse oder eines Balkens, kann beispielsweise eine Vertiefung oder Erhöhung sein oder aber eine bestimmte gröbere oder feinere Oberflächenstruktur aufweisen.

Die Bedieneinheit weist elektrische Sensorelemente auf. Elektrische Sensorelemente basieren auf einer Auswertung von Änderungen der elektrischen Kapazität. Elektrische Sensorelemente können dabei auch als Sensorelektroden bezeichnet werden.

Die Bedieneinheiten, die im Allgemeinen über und unter Wasser funktionieren sollen, können neben der kapazitiven Sensorik auch andere Ein- und Ausgabeelemente beinhalten. Dazu gehören z.B. einzelne LED-Punkte, flächig hinterleuchtete Symbole, 7-Segmentanzeigen und Displays.

Die Bedieneinheit kann außerdem vorteilhaft ein IR-Sensorsystem, umfassend einen Infrarot(IR)-Sender und einen Infrarot(IR)-Empfänger, enthalten, das auf eine Änderung der Intensität einer Reflektion durch Messung und Demodulation der reflektierten IR-Strahlung reagiert.

Vorzugsweise wird dabei die IR-Strahlung des Infrarot(IR)-Senders moduliert, insbesondere bei einer Frequenz im Bereich zwischen 1 KHz und 200 KHz nach einem bestimmten Muster moduliert. Der Infrarot(IR)-Empfänger ist dann dazu eingerichtet, nicht nur auf die Intensität der empfangenen, d.h. reflektierten IR-Strahlung zu reagieren, sondern auch auf das empfangene demodulierte Muster der reflektierten IR-Strahlung.

Auf diese Weise wird verhindert, dass fremde IR-Lichtquellen, wie z.B. Fernbedienungen, zu einer ungewollten Auslösung der Tastensensorik führen. Zudem kann ein Übersprechen der Tasten zueinander verhindert werden, indem jede Taste mit einem anderen Modulationsmuster arbeitet.

Alternativ oder in Ergänzung hierzu kann die Bedieneinheit mindestens einen Helligkeitssensor enthalten, welcher als Signal insbesondere die Helligkeit des Umgebungslichtes (Umgebungshelligkeit) im sichtbaren Bereich messen kann. Der Helligkeitssensor ermöglicht hierbei, dass die Bedieneinheit eine Abdunkelung der Bedieneinheit bei einer Betätigung berücksichtigen kann. Hierzu werden im Allgemeinen die Signale des Helligkeitssensors durch die Steuerungseinheit bzw. die in ihr verwendete Software geeignet ausgewertet. Enthält die Bedieneinheit mehrere Tasten, so können vorteilhaft auch mehrere Tasten, vorzugsweise jede Taste, einen Helligkeitssensor enthalten.

Vorzugsweise wird hierbei ein Algorithmus verwendet, der die relativ langsamen Änderungen der Umgebungshelligkeit im Vergleich zur schnellen Änderung bei einer Betätigung der Bedieneinheit, insbesondere durch einen Nutzer, kompensiert. Anhand der Änderungsgeschwindigkeit des Signals, des Signalverlaufs und der Signalstärke des mindestens einen Helligkeitssensors kann man, insbesondere wenn mehrere Helligkeitssensoren verwendet werden, zwischen einer Änderung der Umgebungshelligkeit und einer Betätigung einer Taste unterscheiden.

Abschattung der Tasten oder eine Betätigung aller Tasten durch Anlehnen oder durch einen Schattenwurf beim Betätigen einer Taste vermeiden helfen. Der Begriff "Taste" steht hierbei für einen berührungsempfindlichen Bereich der Bedieneinheit.

Erfindungsgemäß ist die Bedieneinheit eine kapazitive Bedieneinheit, wobei ein Sensorelement durch eine strukturierte elektrisch leitfähige Beschichtung gebildet wird. Hierin bedeutet eine kapazitive Bedieneinheit im Allgemeinen eine Bedieneinheit, bei der durch Annäherung und/oder Berührung von Sensorelektroden durch ein Objekt, beispielsweise mit einer Hand, einem Finger, einem Stift oder ähnlichem, ein durch Änderungen der elektrischen Kapazität hervorgerufenes elektrisches Signal erzeugt werden kann. Im Allgemeinen ist hierzu die Frontplatte dem Benutzer zugewandt, so dass die Annäherung und/oder Berührung an der Frontplatte erfolgt.

Die kapazitive Bedieneinheit wird erfindungsgemäß zusammen mit einem IR-Sensorsystem und/oder einem Helligkeitssensor verwendet. Hierdurch wird vorteilhaft die Bedienungssicherheit erhöht. Jede Taste würde dabei vorzugweise sowohl durch ein kapazitives als auch durch ein optisches Verfahren hinsichtlich einer Betätigung ausgewertet. Hierbei stehen der Begriff "kapazitives Verfahren" für ein Auswertungsverfahren von gemessenen Kapazitätssignalen und der Begriff "optisches Verfahren" für ein Auswertungsverfahren von gemessenen Signalen des IR-Sensorsystems und/oder des Helligkeitssensors. Die tatsächlichen Messvorgänge bei beiden Verfahren können dabei gleichzeitig oder hintereinander erfolgen. Die Abtast- bzw. Messfrequenz kann sich bei allen Varianten im Ruhezustand und im aktiven Zustand des Systems unterscheiden. Mit "Ruhezustand" ist hier der Gerätezustand gemeint, in dem das Gerät ausgeschaltet ist und keine Funktion ausführt und durch den Benutzer eingeschaltet oder anderweitig aktiviert werden kann. Als "aktiver Zustand wird der Gerätezustand bezeichnet, in dem alle Funktionen ausgeführt werden und in dem erweiterte Benutzerinteraktionen erfolgen, z.B. die Steuerung der Helligkeit einer Beleuchtung.

Für die erfindungsgemäße kapazitive Bedieneinheit kann die Messung der Kapazität beispielsweise mit einer fest eingestellten Frequenz, mehreren unterschiedlichen Frequenzen oder mit einer PRS (Pseudo Random Sequence, d.h. einem mit Rauschen beaufschlagten Frequenzspektrum) erfolgen. Besonders letzteres verbessert das EMV-Verhalten des Systems, da die gestrahlten Emissionen der elektrischen und magnetischen Felder im Frequenzbereich ab 10 MHz geringer sind. In diesem Frequenzbereich sind bei üblichen kapazitiven Sensoren Spitzen im Frequenzspektrum sichtbar, die je nach Sensorgeometrie und Auswertungsverfahren über den erlaubten Grenzwerten für das Einsatzgebiet des Geräts liegen können. Beim Einsatz von PRS werden diese Spitzen durch breitere Erhebungen mit geringerem Pegel ersetzt, was die Einhaltung der Grenzwerte erleichtert.

Zusätzlich ist auch die Resistenz gegenüber gestrahlter Immission in diesem Frequenzbereich höher, da EMV-Störungen oft mit nur einer bestimmten Frequenz auf das Gerät einwirken. Wenn die Frequenz der Auswertung und die der Störung zusammentreffen, kann das zur ungewollten Auslösung der Sensorik und der damit verknüpften Gerätefunktionen führen. Da hier die Auswertefrequenz nicht nur genau eine Frequenz ist, wird die Gefahr der ungewollten Auslösung deutlich reduziert.

Die Messung mit mehreren Frequenzen liefert ein Spektrum, aus dem man eine Berührung unter Wasser leichter ermitteln kann und man ebenfalls Fehlauslösungen aufgrund von elektromagnetischen Einwirkungen erkennen kann. Üblicherweise wirkt ein äußerer Einfluss nur auf bestimmte Frequenzen ein und man kann diesen Einfluss von einer gewollten Betätigung anhand des Spektrums unterscheiden.

Die Messung der Kapazität kann erfindungsgemäß prinzipiell auf zwei Wegen erfolgen, nämlich als Eigenkapazität (Self Capacitance) oder als gegenseitige Kapazität (Mutual Capacitance).

Hinsichtlich der "Self Capacitance" erfolgt die Messung der elektrischen Kapazität der Taste, d.h. insbesondere von deren Tastenfläche, zur Umgebung. Das System reagiert auf die Erhöhung oder Verringerung dieser gemessenen Kapazität bei Betätigung. Zusätzliche Sensorflächen und Programmlogiken werden eingesetzt, um die Zustände über und unter Wasser zu unterscheiden und einen robusten Betrieb zu gewährleisten.

Hinsichtlich der "Mutual Capacitance" erfolgt die Messung der elektrischen Kapazität von zwei Hälften der Fläche einer Taste zueinander. Die Bedieneinheit reagiert auf die Erhöhung oder Verringerung dieser gemessenen Kapazität bei Betätigung.

Zusätzliche Sensorflächen und Programmlogiken können in einer erfindungsgemäßen Bedieneinheit eingesetzt werden, um den Zustand über/unter Wasser zu unterscheiden und einen robusten Betrieb zu gewährleisten.

Prinzipiell ist es auch möglich, Sensorelemente mit Self und Mutual Capacitance im selben Gerät einzusetzen, je nachdem, welche Aufgabe die Bedieneinheit bzw. die darin angeordneten kapazitiven Sensoren erfüllen soll (Erkennung von Berührungen, Wassererkennung usw.).

Die erfindungsgemäße Bedieneinheit umfasst mindestens zwei Sensorelemente, die unabhängig voneinander als Sensortaste oder Slider ausgestaltet sind, die mit einem Mikrocontroller verbunden sind, wobei Sensortaste und/oder Slider auf eine Berührung oder Annäherung durch einen Menschen mit einer Änderung einer Kapazität reagieren und die Steuerungseinheit ausgestaltet ist, um aus dem Ausmaß (Sensorhub) der Änderung der Kapazität sowie deren zeitlicher Änderung bei mindestens zwei Sensorelementen auf eine Berührung oder Annäherung durch einen Menschen zu schließen und außerdem zu erkennen, ob sich die kapazitive Bedieneinheit im Kontakt mit Wasser oder außerhalb von Wasser befindet.

Erfindungsgemäß können die Eingaben auf den Tasten einer kapazitiven Bedieneinrichtung im Sinne der Erfindung so ausgewertet werden, dass z.B. ein Fingerdruck, eine aufgelegte Handfläche oder eine Annäherung mit dem Handrücken auch unter Wasser erkannt werden können. Hierbei sind insbesondere eine oder mehrere Tastenflächen (z.B. als Leiterbahn auf Glas) an einen Mikrocontroller angeschlossen. Diese Flächen können die gleiche oder unterschiedliche Geometrie haben. Der Mikrocontroller misst dann in der Regel mehrmals pro Sekunde die Kapazität der Tastenflächen und bewertet das gemessene Signal, um eine Betätigung zu erkennen.

Vorzugsweise stellt jedes Sensorelement (Sensortaste und jeder lineare Slider (mindestens 2, in der Regel 5 oder mehr Segmente)) ein auszuwertendes Element der Bedieneinheit dar. Diese Sensorelemente werden vorzugsweise nacheinander ausgewertet. Dabei wird vorteilhaft mit einer einzigen Abtastfrequenz gearbeitet. Bewertungskriterien wie absolute Signalstärke, die relative Signalstärke der Elemente zueinander und der zeitliche Verlauf der Signale für eine Auswertung werden im Allgemeinen herangezogen. Auch ist eine Auslegung auf verschiedene Wasserarten (Leitungswasser, Badewasser mit Pflegezusätzen, chloriertes Wasser, Salzwasser) möglich.

Vorzugsweise wird bei einem Verfahren zum Betrieb der erfindungsgemäßen kapazitiven Bedieneinheit zur Erkennung eines Fingers unter Wasser nicht nur der positive Sensorhub der Fläche bewertet, sondern auch der zeitliche Verlauf der Änderung sowohl in positiver als auch in negativer Richtung. Vorzugsweise wird dabei das Verhalten der Sensorflächen relativ zueinander bewertet. Das ist vorteilhaft, da sich das Medium Wasser hinsichtlich der Ausbreitung des elektrischen Feldes anders verhält als Luft.

Die erfindungsgemäßen Bedieneinheiten können auf unterschiedliche Wasserarten ausgelegt werden, unter anderem Leitungswasser, Badewasser mit Pflegezusätzen und chloriertes Wasser. Diese Unterschiede können insbesondere durch eine angepasste, in der Steuereinrichtung der Bedieneinheit hinterlegte Software berücksichtigt werden.

Die erfindungsgemäße Bedieneinheit bietet die Möglichkeit, eine Abstimmung per Softwareparameter auf Betrieb in Süßwasser oder Salzwasser vorzunehmen. Eine Änderung der Hardware ist dabei in der Regel nicht erforderlich. Die Auswahl des Betriebsmodus kann dabei beispielsweise mittels Tastenkombination oder Tastenfolge oder per digitaler Schnittstelle, z.B. per Infrarot-Fernbedienung oder USB oder I2C oder UART, erfolgen. Über diese Schnittstelle können prinzipiell auch andere Einstellungen vorgenommen werden.

Für den Einsatz in Wasser, das mit Luftblasen durchsetzt ist, z.B. in einem Whirlpool, wird im Allgemeinen ein Algorithmus in der Software der Steuerungseinheit benötigt, der zusätzlich zur zeitlichen Änderung eines Tastensignals auch den abgeleiteten oder integrierten Wert mit einbezieht. Eine Erweiterung des Algorithmus in Hinblick auf einen Einsatz der Bedieneinheit in leicht verschmutztem oder trübem Wasser ist für die optischen Verfahren (bei der Verwendung eines IR-Systems und/oder eines Helligkeitssensors) zweckdienlich. Damit die Bedieneinheit auch unter extremen Bedingungen keine Fehlfunktion aufweist, kann vorzugsweise die Bedieneinheit bzw. deren Steuerungseinheit so ausgelegt sein, dass sich die Bedieneinheit deaktiviert, wenn sie kein Wasser mehr erkennt, oder sich selbst neu parametriert, sodass auch eine Verwendung über Wasser möglich ist.

Erfindungsgemäß bevorzugt ist auf beiden Seiten einer optional verwendeten Sensorplatte jeweils mindestens eine keramische Leitstruktur angeordnet.

Erfindungsgemäß ist die Frontplatte aus Glas. Dies hat den Vorteil, dass der Aufbau der Bedieneinheit von einem Benutzer aus gesehen hinter der Frontplatte liegen kann und die Bedieneinheit durch die Frontplatte optisch ansprechend gestaltet werden kann. Zudem bietet Glas gute Witterungsbeständigkeit und gewährleistet somit den Schutz der Bedieneinheit. Hierzu hat die Frontplatte im Allgemeinen eine Dicke von 1 bis 10 mm, vorzugsweise von 2 bis 5 mm, besonders bevorzugt von 3 bis 4 mm. Zudem kann eine solche Frontplatte den Aufbau der Bedieneinheit sowie ggf. weitere Komponenten gut tragen. Vorzugsweise wird für die Frontplatte Floatglas verwendet.

Außerdem ist Glas leicht zu reinigen, was den Einsatz auch in solchen Bereichen ermöglicht, in denen eine häufige Reinigung erforderlich ist, insbesondere auch in Bereichen, in denen es auf eine gute Hygiene ankommt. Weiterhin lassen sich auf Glas transparente und nicht-transparente Bereiche erzeugen, wobei transparente Bereiche insbesondere für eine Hinterlegung der Bedieneinheit mit einem Display vorteilhaft sind. Dabei können beispielsweise auf der Frontplatte Leuchtmittel wie Leuchtdioden angebracht sein. Außerdem kann die Frontplatte vorteilhaft entspiegelt sein und bevorzugt eine ESD-Schutzschicht zur Vorbeugung gegen elektrostatische Entladung (ESD, electrostatic discharge) aufweisen. Vorzugsweise hat die Frontplatte eine Dicke im Bereich von 1 mm bis 10 mm.

Bevorzugt weist die Frontplatte mindestens einen transparenten Bereich auf, insbesondere mehrere transparente und nicht-transparente Bereiche. Besonders bevorzugt ist der Sensorbereich einer optional vorgesehenen Sensorplatte vom Benutzer aus gesehen im Wesentlichen hinter dem transparente Bereiche aufweisenden Teil der Frontplatte angeordnet. Hinter einem nicht-transparenten Bereich ist vorteilhaft eine Auswerteelektronik für die elektrischen Signale der mechanischen und/oder elektrischen Sensorelemente, z.B. von Sensorelektroden, angeordnet. Ganz besonders bevorzugt ist vom Benutzer aus gesehen hinter der Bedieneinheit in transparenten Bereichen der Frontplatte ein Display angeordnet.

Eine Erfassung von reflektierter IR-Strahlung ist dabei vorzugsweise auch durch eine weiß oder schwarz bedruckte Frontscheibe aus Glas möglich. Dies ermöglicht ein besonders hochwertig wirkendes Design der Front bzw. Frontscheibe.

Auf einer ersten Oberfläche der Frontplatte ist vorzugsweise die Auswerteelektronik angeordnet oder zumindest angeschlossen. Im Allgemeinen handelt es sich bei der ersten Oberfläche der Frontplatte um die dem Benutzer abgewandte Oberfläche der Frontplatte. Somit befindet sich die Auswerteelektronik vorzugsweise auf der dem Benutzer abgewandten Seite der Frontplatte.

Der Begriff "Auswerteelektronik" umfasst elektronische Bauteile, Leiterbahnstrukturen, Lötverbindungen und ggf. weitere Komponenten. Die Auswerteelektronik kann beispielsweise direkt auf der Frontplatte, auf einem Flex-Kabel oder auf einer separaten Leiterplatte angeordnet sein. Bei Verwendung einer separaten Leiterplatte kann diese wiederum auf der ersten Oberfläche der Frontplatte angeordnet sein. In diesem Fall weist die Leiterplatte eine erste und eine zweite Seite auf, wobei Leiterbahnstrukturen, Lötverbindungen und elektronische Bauteile, und ggf. auch weitere Komponenten auf der ersten Seite der Leiterplatte angeordnet sind. Dabei kann die Leiterplatte auch zwei oder mehr Lagen, bevorzugt vier Lagen, aufweisen. Vorteilhaft ist die zweite Seite, d.h. die Seite ohne die genannten Bauelemente, auf geeignete Weise an der Frontplatte, insbesondere deren erster Seite, befestigt. Vorzugsweise weist die erfindungsgemäße kapazitive Bedieneinheit keine separate Leiterplatte auf.

Eine in der Bedieneinheit optional verwendete Sensorplatte besteht vorzugsweise aus Glas mit einer Dicke im Bereich von 0,2 bis 2,0 mm, vorzugsweise im Bereich von 0,3 bis 1,5 mm, besonders bevorzugt im Bereich von 0,5 bis 1,1 mm und ganz besonders bevorzugt im Bereich von 0,7 bis 1,1 mm. Hierbei ist es bevorzugt, dass zwischen Frontplatte und Sensorplatte mindestens ein Abstandshalter angeordnet ist und eine keramische Leitstruktur der Sensorplatte über mindestens einen Federkontakt kontaktiert ist.

Die Dicke der Sensorplatte ist die Dicke ohne eine Beschichtung. Der Aufbau der erfindungsgemäßen Bedieneinheit kann somit dünn gehalten werden. Ein möglicher Parallaxenfehler, beispielsweise bei Vorhandensein eines hinter der Bedieneinheit angeordneten Displays, bleibt dann klein. Außerdem ist es bei Ausführungsformen, bei denen die Sensorplatte auf beiden Oberflächen elektrisch leitfähige Schichten aufweist, vorteilhaft, dass der Abstand zwischen diesen elektrischen Schichten gering ist. Die Sensorplatte kann zudem vorteilhaft entspiegelt sein.

Auf der Sensorplatte ist vorzugsweise mindestens eine keramische Leitstruktur aus einer eingebrannten keramischen Leitpaste angeordnet. Unter "Leitstruktur" wird hierin eine Struktur bzw. ein Muster aus elektrisch leitfähigen Elementen verstanden, beispielsweise aus Leiterbahnen und Widerständen. Vorzugsweise umfasst die Leitstruktur insbesondere Leiterbahnen, die einen möglichst geringen Widerstand aufweisen, vorteilhaft inklusive Pads, z.B. Lötpads und Anschlusspads. Zwischen Leitstruktur und Sensorplatte kann eine weitere Schicht vorhanden sein, beispielsweise eine Isolationsschicht oder eine die Schmelzverbindung verbessernde Schicht. Bevorzugt ist die Leitstruktur jedoch zumindest teilweise direkt auf der Sensorplatte angeordnet, d.h. ohne dass andere Materialien zwischen Leitstruktur und Sensorplatte angeordnet sind. Dabei ist es jedoch vorzugsweise nicht ausgeschlossen, dass die Leitstruktur auch teilweise nicht direkt auf der Sensorplatte angeordnet sein kann. Zudem können je nach Layout Überkreuzungen bzw. Tunnelungen vorkommen.

Die keramische Leitstruktur ist aus einer eingebrannten keramischen Leitpaste ausgebildet. Unter "keramischer Leitstruktur" wird hierbei insbesondere eine anorganische Leitstruktur verstanden. Eine solche keramische Leitstruktur, die aus einer eingebrannten keramischen Leitpaste ausgebildet ist, weist eine hohe Beständigkeit und gute Anhaftung auf der Frontplatte oder der Sensorplatte auf. Zudem kann hierauf eine Lötverbindung angebracht werden.

Unter "keramischer Leitpaste" wird eine einbrennbare Paste verstanden, die in der Regel sowohl eine keramische Komponente als auch eine Metallkomponente enthält. Solche Pasten sind beispielsweise im Bereich der Dickschichttechnik (auch als "Dickfilmtechnik" bezeichnet) bekannt. Neben der keramischen Komponente und der Metallkomponente enthalten solche einbrennbaren Pasten in der Regel weitere Zusätze wie z.B. ein Lösungsmittel, beispielsweise mindestens ein Alkohol wie Terpineol, das die Rheologie der Paste beeinflusst. Dies ist insbesondere bei einem Aufbringen der Paste mit einem Druckprozess von Bedeutung. Bevorzugt beträgt in der einbrennbaren Paste der Anteil der keramischen Komponente 10 - 30 Gew.-%, der Anteil der Metallpartikel, die vorzugsweise eine Korngröße von nicht mehr als 15 µm aufweisen, dabei insbesondere Silberpartikel, 60 - 90 Gew.-%, bevorzugt 70 - 85 Gew.-%, und der Anteil an Lösungsmittel 5 - 10 Gew.-%, jeweils bezogen auf die Gesamtheit der Leitpaste. Die keramische Leitpaste kann niedrig- oder hochschmelzend sein. Als niedrigschmelzende Paste wird hierin eine Paste mit einem Schmelzpunkt von 500 - 600°C, bevorzugt 500 - 540°C, und als hochschmelzende Paste wird eine Paste mit einem Schmelzpunkt von 600 - 700°C, bevorzugt von 650 - 680°C, verwendet.

Die keramische Komponente der Leitpaste bewirkt deren Anhaftung zum Glassubstrat, d.h. zur Front- und/oder Sensorplatte. So kann während des Einbrennens der Keramikanteil der auf das Substrat aufgetragenen keramischen Leitpaste mit der Oberfläche der Dünnglas-Sensorplatte verschmelzen, so dass auf diese Weise eine feste Verbindung der keramischen Leitpaste mit der Front- und/oder Sensorplatte entsteht. So wird eine besonders gute Anhaftung zum Glassubstrat erreicht. Zudem wird so eine hohe Beständigkeit gegenüber Umwelteinflüssen wie z.B. UV-Strahlung und beispielsweise bei der Weiterverarbeitung verwendeten Klebstoffen ermöglicht.

Die keramische Komponente besteht hierbei im Allgemeinen aus anorganischen, nichtmetallischen Materialien, die in der Regel kristallin sind und metallische und nicht-metallische Elemente enthalten. Vorzugsweise ist die keramische Komponente Glasfritte. Ausdehnungskoeffizient und Schmelzbereich der Glasfritte sind vorteilhaft an das Trägersubstrat angepasst. Im Allgemeinen eignen sich als keramische Komponente besonders Metalloxide, Metallnitride, Metallcarbide oder eine Mischung dieser Materialien. Die keramische Komponente liegt in der Regel als Pulver oder als Dispergat vor.

Durch die Metallkomponente der Leitpaste wird eine möglichst hohe Leitfähigkeit der Leitpaste bereitgestellt. Dementsprechend sollte die Leitpaste gut leitende Materialien enthalten. Als Metallkomponente sind insbesondere Edelmetalle wie z.B. Silber, Gold, Platin und Palladium bevorzugt. Ganz besonders ist als keramische Leitpaste eine Silberleitpaste bevorzugt. Die genannten Edelmetalle können einzeln oder in Kombination verwendet werden. Auch Legierungen von Edelmetallen, beispielsweise aus Gold oder Silber mit Platin oder Palladium, können verwendet werden. Der Vorteil von Edelmetallen als Metallkomponente ist, dass diese nicht unter Schutzatmosphäre eingebrannt werden müssen. Darüber hinaus können auch Nichtedelmetalle als Metallkomponente verwendet werden, solange eine gute Leitfähigkeit und Beständigkeit gewährleistet sind. Auch diese Metalle können einzeln, in Kombination oder als Legierung, sowohl untereinander wie auch mit Edelmetallen eingesetzt werden. Bei Nichtedelmetall-enthaltenden Leitpasten sind solche, die Kupfer enthalten, bevorzugt.

In den keramischen Leitpasten beträgt der durchschnittliche Durchmesser der Metallpartikel im Allgemeinen nicht mehr als 15 µm, vorzugsweise von 1 bis 15 µm. Besonders bevorzugt weist die keramische Leitpaste Silberpartikel auf. In der eingebrannten keramischen Leitpaste sind die Metallpartikel im Allgemeinen derart miteinander in Kontakt, dass eine durchgehende elektrisch leitfähige Struktur vorliegt.

Im Allgemeinen beträgt die Breite der keramischen Leitstruktur aus einer eingebrannten keramischen Leitpaste nicht mehr als 1 mm, bevorzugt nicht mehr als 0,3 mm und besonders bevorzugt nicht mehr als 0,2 mm. Die Dicke (Höhe) der keramischen Leitstruktur aus einer eingebrannten keramischen Leitpaste beträgt vorzugsweise nicht mehr als 30 µm, besonders bevorzugt nicht mehr als 20 µm. Auf diese Weise kann eine besonders dünne Bedieneinheit erreicht werden.

Die kapazitive Bedieneinheit weist im Allgemeinen Sensorelektroden auf. Diese können erfindungsgemäß insbesondere ebenso wie die keramische Leitstruktur aus einer eingebrannten keramischen Leitpaste ausgebildet sein oder aus einer im Wesentlichen transparenten, strukturierten elektrisch leitfähigen Schicht bestehen.

In einer bevorzugten Ausführungsform der Bedieneinheit ist daher die auf der Frontplatte und/oder der Sensorplatte angeordnete strukturierte elektrisch leitfähige Schicht im Wesentlichen transparent.

"Im Wesentlichen transparent" bedeutet hierin, dass die strukturierte elektrisch leitfähige Schicht zu mindestens 80% durchlässig ist in Bezug auf elektromagnetische Wellen, insbesondere im Bereich des sichtbaren Lichts. Insbesondere bedeutet "im Wesentlichen transparent" auch, dass die elektrisch leitfähige Schicht für den Betrachter der Bedieneinheit durchsichtig erscheint. Dies kann durch die Wahl entsprechender Materialien, wie beispielsweise Indiumzinnoxid (ITO), oder durch geeignete Strukturierung, wie beispielsweise mit Silber-Nanodrähten, die so dünn sind, dass sie vom Betrachter nicht wahrgenommen werden, erreicht werden.

Dabei kann es sich beispielsweise um gefloatetes oder gezogenes Glas handeln. Der Einsatz einer solchen Sensorplatte hat einerseits den Vorteil, dass durch die UV-Beständigkeit von Glas die erfindungsgemäße Bedieneinheit auch im Außenbereich gut einsetzbar ist. Insbesondere werden dabei sehr dünne Bedieneinheiten ermöglicht, die ein geringes Gesamtgewicht sowie eine geringe Gesamtdicke aufweisen.

Die im Wesentlichen transparente, elektrisch leitende Schicht ist strukturiert, insbesondere wenn sie als gleichförmige Schicht auf einer Frontplatte oder Sensorplatte vorliegt, wobei hier die Strukturierung beispielsweise über einen Ätz- oder Laserablationsschritt erfolgt. Die Strukturierung wird in der Regel entsprechend der Funktion der elektrisch leitfähigen Schicht vorgenommen, also beispielsweise als Sensorelektrode oder als Leiterbahn zur Kontaktierung, wobei eine als Sensorelektrode strukturierte im Wesentlichen transparente, elektrisch leitfähige Schicht bevorzugt ist. Die Sensorelektroden können vielfältige Formen von einfachen geometrischen Formen, wie Kreise, Rechtecke usw., bis hin zu komplizierten unregelmäßigen Formen aufweisen. Bevorzugt sind Linien aus einem elektrisch leitfähigen Material in X- und Y-Richtung. Dabei können die Linien in X-Richtung von den Linien in Y-Richtung getrennt in mehreren elektrisch leitfähigen Schichten vorliegen oder gemeinsam in einer elektrisch leitfähigen Schicht, beispielsweise in einer gitterartigen Anordnung. Beispielsweise kann eine elektrisch leitfähige Schicht auf einer ersten Oberfläche der Frontplatte oder aber einer Sensorplatte vorliegen und/oder eine elektrisch leitfähige Schicht auf einer zweiten Oberfläche der Sensorplatte.

Die im Wesentlichen transparente, elektrisch leitfähige Schicht ist im Allgemeinen eine Halbleiteroxidschicht oder druckbare Elektronik wie Silber-Nanodrähte. Eine im Wesentlichen transparente, elektrisch leitfähige Halbleiteroxid-Schicht enthält vorzugsweise ITO, Zinkoxid, mit Antimon dotiertes Zinn(IV)-oxid (ATO), mit Aluminium dotiertes Zinkoxid (AZO) oder mit Fluor dotiertes Zinn(IV)-oxid (FTO) oder besteht aus diesen. Vorzugsweise ist die im Wesentlichen transparente, elektrisch leitfähige Halbleiteroxid-Schicht strukturiert, beispielsweise um als Sensorelektrode im Sinne der vorliegenden Erfindung, also insbesondere als kapazitive Sensorelektrode, verwendet zu werden.

Im Allgemeinen wird die im Wesentlichen transparente, elektrisch leitfähige Schicht durch Sputtern auf der Sensorplatte erzeugt. Andere Herstellungsmethoden sind möglich. Beispielsweise kann die Sensorplatte mit einem Film aus einem elektrisch leitfähigen Material mit einem geeigneten Druckverfahren, z.B. Siebdruck, auf die Sensorplatte aufgebracht und anschließend eingebrannt werden. Beispielsweise sind auch Dünnglasplatten mit einer ITO-Beschichtung auf einer oder auf beiden Seiten kommerziell erhältlich. Z.B. kann mit ITO beschichtetes Glas direkt im Rahmen einer Floatglas-Herstellung erhalten werden.

Besonders bevorzugt weist die eine im Wesentlichen transparente, elektrisch leitfähige Halbleiteroxid-Schicht auf der Sensorplatte Indium-Zinn-Oxid (ITO) auf. Beispielsweise wird eine ITO-Beschichtung entsprechend der Form der erwünschten Sensorelektroden durch einen Ätz- oder Laserablationsschritt strukturiert, um z.B. Linien in X- und/oder Y-Richtung zu erhalten.

Falls in der kapazitiven Bedieneinheit vorhanden, ist die im Wesentlichen transparente, elektrisch leitfähige Schicht vorzugsweise mit der keramischen Leitstruktur elektrisch leitfähig verbunden, so dass elektrische Signale von der im Wesentlichen transparenten, elektrisch leitfähigen Schicht über die keramische Leitstruktur und vorzugsweise über ein weiteres Element, wie z.B. ein Flex-Kabel, einen Federkontakt oder eine Metallklammer, an die Auswerteelektronik geleitet werden können. Bevorzugt werden die entsprechenden elektrischen Signale, beispielsweise von den X- und Y-Linien der Sensorelektroden, über die Leitstrukturen aus eingebrannter keramischer Leitpaste auf der Sensorplatte zu einem Anschluss an der Sensorplatte geleitet, z.B. zu einem Flex-Kabel oder einem Federkontakt, über das/den sie weiter zu der meist nicht auf der Sensorplatte befindlichen Auswerteelektronik geführt werden können.

Bevorzugt ist die mindestens eine keramische Leitstruktur und, falls vorhanden, auch die im Wesentlichen transparente, elektrisch leitfähige Schicht auf einer der Frontplatte zugewandten ersten Oberfläche der optional verwendeten Sensorplatte angeordnet. Dies hat den Vorteil, dass der Abstand zwischen der zweiten Oberfläche der Frontplatte, auf der insbesondere eine Berührung durch einen Benutzer erfolgt, und Sensorelektroden sehr gering gehalten wird, wodurch eine sehr genaue Abbildung der Berührung erzielt wird. Falls mehr als eine im Wesentlichen transparente, elektrisch leitfähige Schicht und/oder keramische Leitstruktur aus einer eingebrannten keramischen Leitpaste auf der der Frontplatte zugewandten ersten Oberfläche der Sensorplatte angeordnet werden, können diese ggf. voneinander getrennt angeordnet werden, indem geeignete, im Allgemeinen isolierende Schichten zwischen den elektrisch leitfähigen Schichten angebracht werden. Solche Schichten sind z.B. solche aus gedruckten Dickschicht-Isolationspasten, Siliziumdioxid (SiO₂)-enthaltende Schichten, die vorzugsweise aufgesputtert werden oder Filme aus einem Kunststoff oder einer Keramik, wobei SiO₂-Schichten bevorzugt werden. Vorzugsweise ist jedoch genau eine im Wesentlichen transparente, elektrisch leitfähige Schicht und/oder keramische Leitstruktur aus einer eingebrannten keramischen Leitpaste auf der der Frontplatte zugewandten ersten Oberfläche der Sensorplatte angeordnet.

In einer besonders bevorzugten Ausführungsform der Erfindung weist die Bedieneinheit eine Beleuchtungseinheit auf, die mindestens ein Leuchtmittel wie z.B. eine Leuchtdiode beinhaltet. Erfindungsgemäß ist es bevorzugt, dass auf einer dem Inneren der Bedieneinheit zugewandten ersten Oberfläche der Frontplatte, die mindestens teilweise mit mindestens einer lichtundurchlässigen Schicht beschichtet ist, ein Gehäuse angeordnet ist, dessen innere Oberfläche mindestens teilweise Lichtstrahlen reflektieren kann; und mindestens ein in einem Raum zwischen dem Gehäuse und der ersten Oberfläche der Frontplatte angeordnetes Leuchtmittel, wobei vom Leuchtmittel erzeugte Lichtstrahlen mindestens teilweise in die Frontplatte gelangen können. Vorzugsweise umfasst mindestens ein Teil der inneren Oberfläche eine diffus reflektierende Oberfläche.

In einer bevorzugten Variante der kapazitiven Bedieneinheit ist auf beiden Seiten der Sensorplatte jeweils mindestens eine keramische Leitstruktur angeordnet. Vorzugsweise ist hierbei auf beiden Seiten der Sensorplatte zusätzlich mindestens eine im Wesentlichen transparente, elektrisch leitfähige Schicht angeordnet. Die mindestens eine keramische Leitstruktur und gegebenenfalls auch die mindestens eine elektrisch leitfähige Schicht auf der der Frontplatte zugewandten ersten Oberfläche und die mindestens eine weitere keramische Leitstruktur und gegebenenfalls auch die mindestens eine weitere elektrisch leitfähige Schicht auf der der Frontplatte abgewandten zweiten Oberfläche sind durch die Sensorplatte voneinander getrennt. Bevorzugt umfasst eine im Wesentlichen transparente, elektrisch leitfähige Schicht auf der der Frontplatte zugewandten ersten Oberfläche Linien aus leitfähigem Material in X-Achsen-Richtung und eine weitere im Wesentlichen transparente, elektrisch leitfähige Schicht auf der der Frontplatte abgewandten zweiten Oberfläche Linien aus leitfähigem Material in Y-Achsen-Richtung oder umgekehrt.

Im Allgemeinen ist die Sensorplatte der ersten Oberfläche der Frontplatte zugewandt angeordnet. Dies bedeutet, dass die Sensorplatte im Allgemeinen vom Benutzer aus gesehen hinter der Frontplatte angeordnet ist. Vorteilhafterweise ist auf der ersten Oberfläche der Frontplatte auch die Auswerteelektronik angeordnet, so dass eine ggf. eingesetzte Sensorplatte der Seite der Frontplatte mit der Auswertelektronik zugewandt ist, um eine vorteilhafte Verbindung von Sensorplatte und Auswerteelektronik zu ermöglichen.

Die Verbindung der optionalen Sensorplatte oder der Frontplatte mit der Auswerteelektronik ist auf vielfältige Art und Weise möglich. Beispielsweise kann eine solche Verbindung über einen Federkontakt oder über ein Flex-Kabel erfolgen.

In einer bevorzugten Ausführungsform hat daher die kapazitive Bedieneinheit eine Frontplatte aus Glas und eine Sensorplatte aus Dünnglas, auf der eine keramische Leitstruktur aus einer eingebrannten keramischen Leitpaste und eine strukturierte im Wesentlichen transparente, elektrisch leitfähige Schicht angeordnet ist,
(a) wobei die Glas-Sensorplatte einer ersten Oberfläche der Frontplatte zugewandt ist;
(b) eine Auswerteelektronik für die elektrischen Signale direkt oder über eine Leiterplatte auf der ersten Oberfläche der Frontplatte angeordnet ist; und
(c) die mindestens eine elektrisch leitfähige Schicht mit der Auswerteelektronik über mindestens einen Federkontakt verbunden ist.
Vorzugsweise ist dabei der Federkontakt über eine Clip-Verbindung an der Sensorplatte befestigt. Im Allgemeinen kann der Federkontakt beispielsweise auch mittels Löten mit der keramischen Leitstruktur verbunden werden.

Gemäß einer noch mehr bevorzugten Ausführungsform der Erfindung erfolgt die Kontaktierung der Leitstrukturen auf der Sensorplatte über ein Flex-Kabel. Das Flex-Kabel ist in der Regel ein Flat-Flex-Kabel, wobei "Flat-Flex-Kabel" insbesondere solche der Typen FFC (flat flex cable) und FPC (flexible printed circuit) einschließt. Das Flat-Flex-Kabel ist im Allgemeinen ein mehradriges Kabel, indem die Adern nicht kreisförmig gebündelt, sondern - zumeist parallel - nebeneinander geführt sind. Das Flex-Kabel weist im Allgemeinen mehrere Adern auf, bevorzugt weist das Flex-Kabel mindestens 5 Adern auf, besonders bevorzugt mindestens 10 Adern. Der Abstand der Adern beträgt in der Regel 0,5 bis 2,54 mm, bevorzugt 1,27 mm.

Die Verbindung des Flex-Kabels mit der Sensorplatte kann unterschiedlich erfolgen, beispielsweise mittels eines anisotrop leitfähigen Klebers. Bevorzugt ist das Flex-Kabel an die optionale Sensorplatte, insbesondere an die keramische Leitstruktur auf der Sensorplatte, gelötet. Insbesondere ermöglicht die Verwendung einer keramischen Leitstruktur im Gegensatz zu beispielsweise organischen Lacken eine Lötverbindung. Bei dieser bevorzugten Ausführungsform ist somit das Flex-Kabel mittels einer verfestigten Lotpaste an der Sensorplatte fixiert. Der Lötprozess kann auf verschiedene Weise erfolgen, beispielsweise als Bügellötprozess. Jedoch ist ein Reflow-Lötprozess bevorzugt. Die Vielzahl der Adern des Flex-Kabels und deren vergleichsweise geringer Anstand erfordern einen präzisen Lötprozess. Durch das Löten ist das Flex-Kabel mit der keramischen Leitstruktur auf der Sensorplatte über eine dauerstabile Lötverbindung verbunden, die große Beständigkeit gewährleistet und die sich im Zusammenhang mit der Leitstruktur aus keramischer Leitpaste über entsprechende Lötpads optimal umsetzen lässt. Zudem kann durch die Lötverbindung in Zusammenwirkung mit den keramischen Leitstrukturen eine komplett anorganische Bedieneinheit erhalten werden.

Eine Auswerteelektronik für die Berührungen oder Annäherungen eines Benutzers kann beispielsweise direkt auf der Frontplatte, auf dem Flex-Kabel oder auf einer separaten Leiterplatte angeordnet sein. Beispielsweise kann die Auswerteelektronik über die Chip-On-Flex-Technologie (COF) auf dem Flex-Kabel angeordnet sein.

Besonders bevorzugt ist eine Ausführungsform, die auf beiden Seiten der Sensorplatte jeweils mindestens eine keramische Leitstruktur aufweist und wobei die auf beiden Seiten der Sensorplatte angeordneten keramischen Leitstrukturen über ein einziges Flex-Kabel kontaktiert sind. Auch hier verbindet das Flex-Kabel die keramischen Leitstrukturen der Sensorplatte vorzugsweise mit der Auswerteelektronik. Dies ermöglicht, dass beispielsweise die auf einer Seite der Sensorplatte angeordneten Sensoren in X-Richtung und die auf der anderen Seite der Sensorplatte angeordneten Sensoren in Y-Richtung durch die keramischen Leitstrukturen, die aus einer eingebrannten keramischen Leitpaste ausgebildet sind, zu einem Anschluss für ein einziges Flex-Kabel zusammengeführt werden. Dabei ist die geringe Dicke der Dünnglas-Sensorplatte von Vorteil. Durch die Verwendung eines einzigen Flex-Kabels wird Material gespart und eine schnellere Montage ermöglicht.

Die Bedieneinheit umfasst mehrere elektrisch leitfähige Sensorschichten. Besonders bevorzugt weist die Bedieneinheit zwei, drei, vier oder fünf elektrisch leitfähige Sensorschichten auf. Auf diese Weise wird ein Mehrlagensensor ermöglicht, bei dem über zusätzliche Sensorschichten weitere Funktionen wie beispielsweise Proximity-Erkennung, Gestenerkennung etc. realisiert werden können.

Ein solcher Mehrlagensensor weist somit mehrere Sensorschichten auf und kann je nach Funktion und entsprechendem Design auch mehrere Passivierungsschichten und/oder Lackschichten umfassen. Insbesondere sind mehrere Schichten, die Leitstrukturen und/oder eine im Wesentlichen transparente, elektrisch leitfähige Schicht umfassen, durch Isolationsschichten, beispielsweise aus Siliziumdioxid, voneinander getrennt.

In einer bevorzugten Ausführungsform ist die optionale Sensorplatte mit der Frontplatte verklebt. Dabei ist eine Klebeschicht zwischen Sensor- und Frontplatte angeordnet. Bevorzugt wird hierbei ein Spezialkleber verwendet, besonders bevorzugt ein OC-Kleber. Vorzugsweise wird die gegebenenfalls eine Leitstruktur und/oder Schicht aufweisende Sensorplatte vollflächig mit der Frontplatte verklebt. Die Dicke der Klebschicht beträgt bevorzugt 0,2 bis 0,5 mm.

In einer weiteren Ausführungsform der kapazitiven Bedieneinheit ist zwischen der Frontplatte und der optional vorhandenen Sensorplatte mindestens ein Abstandshalter angeordnet. Diese Ausführungsform ist vor allem bevorzugt, wenn die Kontaktierung der Leitstrukturen auf der Sensorplatte über Federkontakte erfolgt. Bei dieser Ausführungsform ist die Sensorplatte von der Frontplatte durch einen über den mindestens einen Abstandshalter definierten Abstand getrennt. So kann durch den mindestens einen Abstandshalter ein umlaufend gleicher Abstand zwischen Frontplatte und Sensorplatte erreicht werden.

Der Abstandshalter kann auf verschiedene Art ausgestaltet sein. Jedoch werden bestückbare Bauelemente, wie SMD-Bauteile, beispielsweise Null-Ohm-Widerstände oder auch Kondensatoren oder Kupferblöcke, bevorzugt eingesetzt. Diese Bauelemente können beispielsweise in dem Bestückungsvorgang der Auswerteelektronik mit an der Frontplatte und/oder an einer zur Auswerteelektronik gehörenden Leiterplatte angebracht werden, so dass kein separater Arbeitsgang notwendig ist, um die Abstandshalter anzubringen. Andererseits sind auch andere Ausbildungen der Abstandshalter möglich, wie beispielsweise Kunststoffblöcke. Die Verbindung der Abstandshalter mit der Sensorplatte ist vorteilhaft elastisch, um die oben genannten Vorteile in größtmöglichem Umfang zu gewähren. Beispielsweise wird die Verbindung durch ein geeignetes Haftmaterial hergestellt, bevorzugt durch einen Epoxidharzkleber, der die Elastizität gewährleistet.

Die Anordnung der Abstandshalter erfolgt bevorzugt derart, dass die Abstandshalter für den Benutzer nicht sichtbar sind, beispielsweise in einem nicht-transparenten Bereich der Frontplatte und im Randbereich der Sensorplatte.

Insbesondere ist es bevorzugt, dass bei Verwendung eines Abstandhalters in der Ausführungsform als kapazitive Bedieneinheit der Abstand zwischen der Frontplatte und der Sensorplatte ≤ 1 mm, vorzugsweise ≤ 0,5 mm, besonders bevorzugt ≤ 0,4 mm ist. Ist der Abstand größer, kann es unter Umständen zu Verlusten bei der Genauigkeit der Registrierung des Touchsignals durch die Sensorelektroden, zu Parallaxenfehlern bei hinter der Bedieneinheit angeordnetem Display und/oder zu einem unerwünscht dicken Gesamtaufbau der Bedieneinheit führen. Besonders bevorzugt liegt der Abstand im Bereich von 0,2 bis 0,35 mm.

Weiterhin ist es bei der Abstandshalter aufweisenden Ausführungsform der erfindungsgemäßen Bedieneinheit bevorzugt, dass sich in dem durch die Abstandshalter zwischen Frontplatte und Sensorplatte definierten Zwischenraum ein Füllmaterial befindet. Ein solches Füllmaterial kann beispielsweise ein geeigneter Kleber sein, wie z.B. ein Epoxidharz oder ein OC-Kleber. Bevorzugt wird hier ein OC-Kleber eingesetzt. Das Füllmaterial hat einerseits den Vorteil, dass es den durch den Abstand gebildeten Zwischenraum zwischen Frontplatte und Sensorplatte abdichtet, so dass kein Schmutz eindringen kann. Andererseits ist es insbesondere bei großen Touchscreens mit dünnem Sensorglas möglich, dass durch die Berührung hervorgerufene Erschütterungen der Glasplatte zu einer ungenauen Abbildung der Berührung führen können. Dies kann durch ein geeignetes Füllmaterial vermieden werden.

Besonders bevorzugt ist bei der Abstandshalter aufweisenden Ausführungsform der erfindungsgemäßen Bedieneinheit die Auswerteelektronik direkt auf einer unbeschichteten oder beschichteten ersten Oberfläche der Frontplatte angebracht. Hierin bedeutet "direkt auf einer unbeschichteten oder beschichteten ersten Oberfläche der Frontplatte angebracht", dass die Auswerteelektronik insbesondere nicht auf einer Leiterplatte angebracht ist. Somit dient die Frontplatte aus Glas als Trägermaterial für die Elektronik. Auf diese Weise entfällt die Leiterplatte und eine vorteilhaft geringe Aufbauhöhe der Bedieneinheit ist möglich. Zudem entfällt der Arbeitsschritt der Befestigung der Leiterplatte an der Frontplatte.

In einer bevorzugten Ausführungsform der kapazitiven Bedieneinheit ist die erste Oberfläche der Frontplatte mindestens teilweise mit einer oder mehreren eingebrannten Keramikfarben beschichtet. Darüber hinaus kann auch auf der Sensorplatte eine Beschichtung mit einer eingebrannten Keramikfarbe vorliegen. Die einbrennbare Keramikfarbe hat dabei vorzugsweise eine Einbrenntemperatur, die sich nicht mehr als 20°C von der Einbrenntemperatur der einbrennbaren keramischen Leitpaste unterscheidet. Dies ermöglicht ein vorteilhaftes Einbrennen von Keramikfarbe und Leitpaste in einem Schritt. Eine Beschichtung mit Keramikfarbe kann als Dekorbeschichtung und/oder zur Bereitstellung eines nicht-transparenten Bereiches dienen. Die Beschichtung kann auf verschiedene Weise angebracht werden, beispielsweise durch Aufbringen eines Beschichtungsfilms oder durch geeignete Druckverfahren. Besonders bevorzugt ist das Anbringen der Beschichtung durch Siebdruck. Dabei werden zur Beschichtung besonders bevorzugt keramische und UV-stabile Siebdrucklacke verwendet.

Weiterhin ist es erfindungsgemäß bevorzugt, dass die Frontplatte der Bedieneinheit aus gehärtetem Einscheiben-Sicherheitsglas besteht. Dadurch wird eine kratzfeste Oberfläche und hohe mechanische Festigkeit erzielt. Außerdem dient dies dem Schutz der Bedieneinheit. Somit ist eine Vielzahl von Einsatzmöglichkeiten unter Wasser möglich, die beispielsweise eine robuste Oberfläche der Bedieneinheit erfordern. Insbesondere bietet sich hier eine Kombination mit der Ausführungsform an, bei der die Leiterbahnstrukturen der Auswerteelektronik auf der unbeschichteten oder beschichteten ersten Oberfläche der Frontplatte angebracht werden. Wenn solche Leiterbahnstrukturen und/oder Dekorschichten in die Glas-Frontplatte eingebrannt werden, kann dies durch geeignete Wahl der Brenntemperatur derart erfolgen, dass die Glas-Frontplatte gleichzeitig, also ohne zusätzlichen Arbeitsgang, zum Einscheiben-Sicherheitsglas gehärtet wird.

Bevorzugt ist eine kapazitive Bedieneinheit, bei der die beschichtete erste Oberfläche der Frontplatte erhältlich ist durch gleichzeitiges Einbrennen der Keramikfarben und/oder Leiterbahnstrukturen, beispielsweise bei einer Temperatur im Bereich von 600 bis 700°C.

Gegenstand der Erfindung ist außerdem ein Verfahren zur Herstellung einer Bedieneinheit für einen Einsatz unter Wasser, mit einer Frontplatte aus Glas und elektrischen Sensorelementen, die auf einer Auswertung von Änderungen der elektrischen Kapazität basieren, und einer Steuerungseinheit, wobei die Sensorelemente auf einer einem Inneren der Bedieneinheit zugewandten ersten Oberfläche der Frontplatte und/oder auf einer Sensorplatte platziert sind, wobei auf der Frontplatte und/oder der Sensorplatte, auf der Sensorelemente platziert sind, eine keramische Leitstruktur aus einer eingebrannten keramischen Leitpaste angeordnet ist; wobei ein Sensorelement durch eine strukturierte elektrisch leitfähige Beschichtung gebildet wird, wobei die strukturierte elektrisch leitfähige Beschichtung mit der keramischen Leitstruktur elektrisch leitfähig verbunden ist, und wobei die Bedieneinheit mindestens zwei Sensorelemente umfasst, die unabhängig voneinander als Sensortaste oder Slider ausgestaltet sind, die mit einem Mikrocontroller verbunden sind, wobei Sensortaste und/oder Slider auf eine Berührung oder Annäherung durch einen Menschen an die Bedieneinheit mit einer Änderung einer Kapazität reagieren und die Steuerungseinheit ausgestaltet ist, um aus dem Ausmaß der Änderung der Kapazität sowie deren zeitlicher Änderung bei mindestens zwei Sensorelementen auf eine Berührung oder Annäherung eines Menschen zu schließen und außerdem zu erkennen, ob sich die kapazitive Bedieneinheit im Kontakt mit Wasser oder außerhalb von Wasser befindet, und als Reaktion auf die Berührung oder Annäherung eine Aktion auszulösen, wenn sich die Bedieneinheit unter Wasser befindet, und wobei die Bedieneinheit ein IR-Sensorsystem und/oder einen Helligkeitssensor umfasst, wobei das Verfahren die folgenden Schritte umfasst:
(ii) Aufbringen einer einbrennbaren keramischen Leitpaste auf die Frontplatte und/oder die Sensorplatte und
(iv) Einbrennen der keramischen Leitpaste.

In einer bevorzugten Ausführungsform dieses Verfahrens liegt die Einbrenntemperatur in Schritt (iv) im Bereich von 500 bis 700 °C.

Die Art und Weise des Aufbringens der einbrennbaren keramischen Leitpaste auf die Frontplatte und/oder die Sensorplatte in Schritt (ii) ist erfindungsgemäß nicht besonders eingeschränkt. Jedoch ist es bevorzugt, dass das Aufbringen in Schritt (ii) mittels Siebdruck- oder Tintenstrahltechnik durchgeführt wird. Dies hat den Vorteil, dass kommerziell erhältliche einbrennbare keramische Leitpasten verwendet werden können, die in der Regel auf diese Verfahren abgestimmt sind. Besonders bevorzugt ist die Siebdrucktechnik, da es sich hierbei um ein effizientes und kostengünstiges Verfahren handelt, insbesondere auch hinsichtlich der Anlagentechnik und der auf Siebdruck abgestimmten keramischen Leitpasten. Ist eine besonders hohe Auflösung gefordert, beispielsweise mit Strukturen unter 50 µm, ist die Tintenstrahltechnik bevorzugt, die im Gegensatz zum Siebdruck keine Masken erfordert und eine noch bessere Auflösung bietet. Das Aufbringen in Schritt (ii) kann auch durch andere Techniken erfolgen, beispielsweise durch lasergestützte digitale Druckverfahren wie z.B. die LIFT-Technologie, wobei es sich um ein düsen- und berührungsloses Verfahren handelt.

Beim Aufbringen der einbrennbaren keramischen Leitpaste kann bereits eine gewünschte Strukturierung vorgenommen werden, die beim anschließenden Einbrennen der keramischen Leitpaste fixiert werden kann.

Im Anschluss an das Aufbringen der einbrennbaren keramischen Leitpaste (Schritt (ii)) und vor dem Einbrennen (Schritt (iv)) erfolgt vorzugsweise ein Trocknungsschritt (iii). Hierbei können Lösungsmittel aus der Paste verdampft werden. Beispielsweise kann die Paste einige Minuten bei Raumtemperatur vorgetrocknet werden und anschließend bei einer Temperatur von 80 bis 150 °C für 5 bis 15 min getrocknet werden, wobei die genauen Temperaturen und Zeiten insbesondere von der verwendeten Paste abhängen. Der Trocknungsschritt hat den Vorteil, dass eine spontane Verdampfung der Lösungsmittel bei einer hohen Einbrenntemperatur, die zu Blasen oder Rissen führen könnte, vermieden wird.

In Schritt (iv) erfolgt das Einbrennen der keramischen Leitpaste, wobei die Partikel der Paste, insbesondere beispielsweise die Glasfritte-Partikel, zumindest teilweise mit der Oberfläche der Dünnglas-Sensorplatte verschmelzen. Durch die anschließende Abkühlung des Substrats erstarrt der Keramikanteil, z.B. die Glasfritte, in der Paste und bildet so eine feste mechanische Verbindung zum Substrat. Somit werden die guten Hafteigenschaften der Leitstrukturen auf der Sensorplatte ermöglicht.

Die Einbrenntemperatur liegt vorzugsweise zwischen 500 - 700 °C, besonders bevorzugt zwischen 500 - 540 °C bei Verwendung niedrig schmelzender Pasten oder zwischen 650 - 680 °C bei Verwendung hoch schmelzender Pasten.

Das Einbrennen der einbrennbaren keramischen Leitpaste kann unter sehr unterschiedlichen Bedingungen durchgeführt werden. Die im Verfahren gewählten Bedingungen werden im Allgemeinen von der keramischen Leitpaste und der gewünschten Planarität von Front- und insbesondere Sensorplatte während des Einbrennens abhängen. Beispielsweise werden vorteilhaft niedrig schmelzende Silberpasten mit einem Schmelzbereich von 500 bis 540 °C oder IR-absorbierende Leitpasten eingesetzt. Bei einer bevorzugten Einbrenntemperatur im Bereich von 500° bis 700 °C sollte die Planarität im Wesentlichen erhalten bleiben. Es hat sich erfindungsgemäß als besonders vorteilhaft herausgestellt, wenn beim Einbrennen im Schritt (iv) eine Planarität von ≤ 0,05 mm eingehalten werden kann.

Zu diesem Zweck erfolgt das Einbrennen im Allgemeinen unter Verwendung von speziellen horizontalen Aufnahmevorrichtungen für Durchlaufofen oder von speziellen vertikalen Aufnahmen für Batchofen.

Außerdem werden im Allgemeinen Einbrennparameter wie z.B. die Temperatur, Aufheizzeit, Oszillationsgeschwindigkeit, Luftdruck beim Abkühlen, Abkühlzeit und/oder die Wahl einer geeigneten Wärmequelle, wie z.B. Heizwendel, IR-Strahler, Laserstrahlvorrichtung mit hoher Energiedichte zum punktuellen Einbrennen, auf die Leitpaste und die Front- bzw. Sensorplatte abgestimmt.

Die Art und Weise des Lötens ist erfindungsgemäß nicht eingeschränkt, wobei jedoch Präzision insbesondere hinsichtlich des geringen Abstands der mehreren Adern des Flex-Kabels erforderlich ist. Beispielsweise kann das Löten durch Bügellöten, Thermodenlöten oder Reflowlöten erfolgen, wobei Reflowlöten bevorzugt ist. Beim Reflowlöten (auch "Wiederaufschmelzlöten") wird die Lotpaste bzw. die keramische Leitstruktur nur auf die erforderliche Löttemperatur erwärmt. Der Lotauftrag erfolgt unabhängig davon bereits vor der Bestückung mit elektronischen Bauteilen. In Schritt (iv) wird vorzugsweise nur die keramische Leitstruktur der Sensorplatte an den vorgesehenen Kontaktstellen, d.h. an den Lötpads, belotet. Die Belotung, d.h. das Aufbringen von Lötmittel, kann auf vielfältige Weise, z.B. mit Lotpaste, Lotformteilen, Belotung im Tauch- oder Wellenbad oder elektrochemische Beschichtung erfolgen. Bevorzugt wird Lotpaste verwendet, die den Vorteil hat, dass das Flex-Kabel durch das in der Lotpaste im Allgemeinen enthaltene, klebrige Flußmittel bis zur Lötung auf der Leitstruktur fixiert werden kann. So können auch kleinste Kontaktflächen präzise belotet werden.

Die Erfindung hat zahlreiche Vorteile. Die erfindungsgemäße kapazitive Bedieneinheit ausgestaltet ist, vereint die Möglichkeit einer breiten Anwendbarkeit mit einer einfachen und kostengünstigen Herstellung. Diese Bedieneinheit kann besonders vorteilhaft unter Wasser eingesetzt werden, wo selbst in Anwesenheit von Wasser, oder einer wässrigen Flüssigkeit wie z.B. einer chlorhaltigen wässrigen Flüssigkeit oder Salzwasser, insbesondere auch Meerwasser, Berührungen und/oder Annäherungen insbesondere eines Menschen oder ggf. eines anderen Lebewesens, z.B. eines Fisches, festgestellt werden können. Durch den Einsatz einer insbesondere dünnen Sensorplatte werden im Gesamtaufbau sehr dünne Bedieneinheiten ermöglicht, die zudem ein geringeres Gewicht aufweisen. Gleichzeitig gewährleistet die Verwendung einer eingebrannten keramischen Leitpaste zur Ausbildung der Leitstrukturen eine hervorragende Anhaftung der Leitstrukturen an das Glassubstrat, sei es die Frontplatte oder eine Sensorplatte, sowie eine hohe Beständigkeit gegenüber Umwelteinflüssen, UV-Strahlung und chemischen Einflüssen, beispielsweise auch gegenüber in späteren Verfahrensschritten eingesetzten Klebstoffen. So wird die weitere Verarbeitbarkeit erleichtert und ein breiter Einsatzbereich ermöglicht.

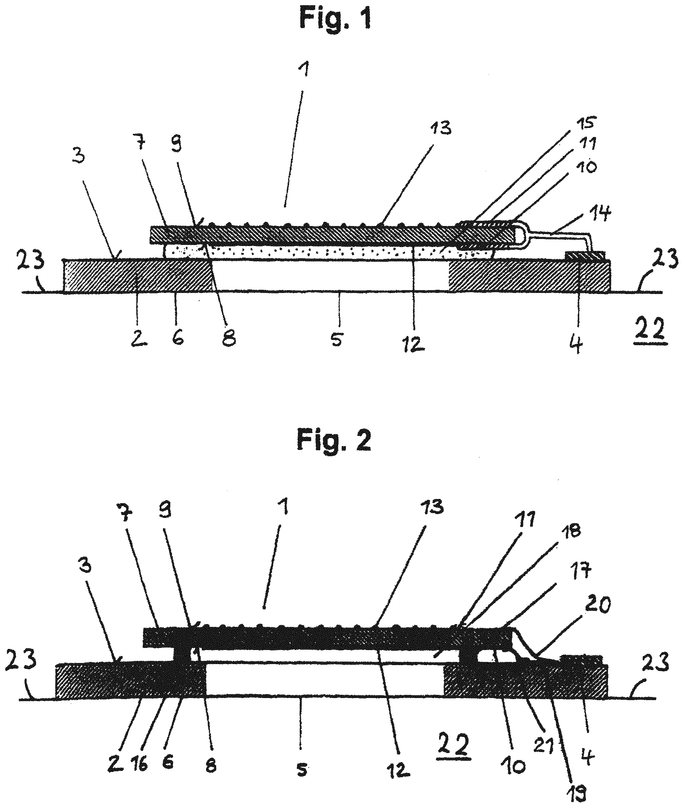

Die Erfindung wird im Folgenden anhand von drei nicht einschränkend gemeinten Ausführungsbeispielen für eine erfindungsgemäße Bedieneinheit illustriert, die besonders gut für den Einsatz unter Wasser, z.B. in einer Wand oder einem Boden eines Schwimmbeckens geeignet ist. Dabei wird Bezug genommen auf die Figuren 1 bis 3.

Fig. 1 zeigt einen Querschnitt durch eine erfindungsgemäße kapazitive Bedieneinheit, bei der auf beiden Seiten einer hier vorhandenen Sensorplatte jeweils eine keramische Leitstruktur und eine strukturierte im Wesentlichen transparente, elektrisch leitfähige Schicht angeordnet ist, wobei die auf beiden Seiten angeordneten Leitstrukturen sowie elektrisch leitfähigen Schichten über ein einziges Flex-Kabel kontaktiert sind.

In der Figur 1 ist ein Querschnitt durch eine kapazitive Bedieneinheit 1 gezeigt, die eine Frontplatte 2 aus Glas mit einer Dicke von 3 mm umfasst. Auf einer ersten Oberfläche 3 der Frontplatte 2 ist eine Auswerteelektronik 4 angeordnet. Die Frontplatte 2 weist einen im Wesentlichen transparenten Bereich 5 und einen nicht-transparenten Bereich 6 auf.

Weiterhin umfasst die kapazitive Bedieneinheit 1 eine Sensorplatte 7 mit einer Dicke von 1,1 mm. Die erste Oberfläche 8 der Sensorplatte 7 ist der ersten Oberfläche 3 der Frontplatte 2 zugewandt angeordnet. Die Sensorplatte 7 weist somit eine der Frontplatte 2 zugewandte erste Oberfläche 8 und eine der Frontplatte 2 abgewandte zweite Oberfläche 9 auf. Auf beiden Seiten der Sensorplatte 7, d.h. auf beiden Oberflächen 8 und 9, ist jeweils direkt eine keramische Leitstruktur 10 und 11 angeordnet, die aus einer eingebrannten keramischen Silberpaste, z.B. mit einer siebdruckgeeigneten Silberleitpaste mit einem Silbergehalt von 60% oder 80%, gebildet ist und Leiterbahnen und Lötpads umfasst. Zudem ist auf beiden Seiten der Sensorplatte 7, d.h. auf beiden Oberflächen 8 und 9, jeweils eine strukturierte im Wesentlichen transparente, elektrisch leitfähige Schicht 12 und 13 angeordnet, die hier als ITO-Schicht ausgebildet ist. Die erste ITO-Schicht 12 ist so strukturiert, dass sie Linien in X-Richtung bildet und die zweite ITO-Schicht 13 ist derart strukturiert, dass sie Linien in Y-Richtung bildet, so dass aus beiden ITO-Schichten 12 und 13 der Sensor gebildet wird. Im Randbereich der Sensorplatte 7 werden (hier nicht sichtbar) die jeweiligen X- und Y-Linien der ITO-Schichten 12 und 13 von den Leiterbahnstrukturen aus keramischer Silberleitpaste 10 und 11 kontaktiert. Die Leiterbahnstrukturen 10 und 11 werden ihrerseits zu einer Anschlussstelle für ein Flex-Kabel 14 mit entsprechenden Lötpads zusammengeführt (hier nicht sichtbar), die ebenfalls im Randbereich der Sensorplatte 7 liegt und für den Benutzer durch den nicht-transparenten Bereich 6 der Frontplatte 2 verdeckt wird.

Die elektrische Verbindung zwischen der auf der Frontplatte 2 angeordneten Auswerteelektronik 4 und den Leitstrukturen 10 und 11 der Sensorplatte 7 ist durch ein Flex-Kabel 14 realisiert, das abwechselnd sowohl die Leitstrukturen 10 auf der der Frontplatte 2 zugewandten ersten Oberfläche 8 der Sensorplatte 7 sowie auch die Leitstrukturen 11 auf der der Frontplatte 2 abgewandten zweite Oberfläche 8 der Sensorplatte 7 kontaktiert. Die Verbindung des Flex-Kabels 14 mit den Leitstrukturen 10 und 11 ist durch eine Lötverbindung mittels einer verfestigten Lotpaste (hier nicht sichtbar) realisiert.

Zwischen der Frontplatte 2 und der Sensorplatte 7 befindet sich bei dieser Ausführungsform eine Klebeschicht 15. Diese Klebeschicht 15 besteht aus einem OC-Kleber (optically clear adhesive) und ist vollflächig, d.h. ohne Unterbrechungen oder Hohlräume ausgebildet.

Zur Durchführung des erfindungsgemäßen Herstellungsverfahrens wird bei der hier gezeigten ersten Ausführungsform zunächst die als Sensorplatte 7 dienende, ganzflächig mit ITO beschichtete Dünnglasplatte durch Ätzen strukturiert, so dass Sensorlinien in X- (Schicht 12) bzw. in Y-Richtung (Schicht 13) sowie ITO-freie Bereiche, insbesondere im Randbereich der Sensorplatte 7, entstehen. Der Ätzschritt wird hierbei je Seite 8 und 9 der Sensorplatte 7 durchgeführt, indem Ätzpaste, beispielsweise eine HF- und chloridfreie, siebdruckgeeignete Ätzpaste, mittels Siebdrucktechnik durch ein Sieb mit den entsprechenden X- oder Y-Linien aufgedruckt wird, die Ätzpaste dann thermisch aktiviert wird, beispielsweise für 15 min bei 150 °C, und anschließend gewaschen wird. In den so entstandenen ITO-freien Bereichen wird dann mittels Siebdruck die keramische Silberleitpaste auf der ersten Oberfläche 8 und anschließend auf der zweiten Oberfläche 9 der Sensorplatte 7 aufgebracht. Die Paste wird dann zunächst bei Raumtemperatur für 5 min und dann bei 120 bis 150 °C für 5 bis 10 min getrocknet. Anschließend wird die Silberleitpaste bei einer Temperatur zwischen 500 und 700 °C eingebrannt.

Im Anschluss wird die Frontplatte 2 mit der Auswerteelektronik 4 mittels SMD-Löten bestückt. Anschließend werden die bei den Leitstrukturen 10 zum Anschluss für das Flex-Kabel 14 vorgesehenen Lötpads mit einer Lotpaste, die einen Schmelzbereich von 230 - 245 °C aufweist belotet, das Flex-Kabel 14 daran fixiert und in einem Reflowlötprozess verlötet. Dann werden die bei den Leitstrukturen 11 zum Anschluss für das Flex-Kabel 14 vorgesehenen Lötpads mit einer Lotpaste, die einen Schmelzbereich von ca. 170°C aufweist, belotet, das Flex-Kabel 14 daran ebenfalls fixiert und in einem Reflowlötprozess verlötet. Im Anschluss wird ein OC-Kleber im vorgesehenen Bereich vollflächig auf die Frontplatte 2 und/oder auf die Sensorplatte 7 aufgebracht. Dann wird die Sensorplatte 7 durch einfaches Andrücken an der Frontplatte 2 angebracht. Durch die vorbereitete Klebeschicht 15 haftet die Sensorplatte 7 an der Frontplatte 2.

22 bedeutet Wasser oder allgemeiner eine wässrige Flüssigkeit und 23 eine Behälterwand, z.B. eines Schwimmbeckens oder eines Aquariums, in welche die Bedienvorrichtung integriert ist.

Fig. 2 zeigt einen Querschnitt durch eine erfindungsgemäße kapazitive Bedieneinheit 1 gemäß einer zweiten Ausführungsform der Erfindung, bei der auf beiden Seiten 8 und 9 der Sensorplatte 7 jeweils eine keramische Leitstruktur 10, 11 und eine strukturierte im Wesentlichen transparente, elektrisch leitfähige Schicht 12, 13 angeordnet ist. Im Unterschied zur ersten Ausführungsform von Fig. 1 befinden sich hier zwischen Frontplatte 2 und Sensorplatte 7 Abstandshalter 16, 17, welche bei der hier gezeigten Ausführungsform mittels eines Epoxidklebers mit der Frontplatte 2 verklebt sind. Durch die Abstandshalter 16 und 17 ist ein Zwischenraum 18 zwischen Frontplatte 2 und Sensorplatte 7 gebildet. Die Bestückung der Frontplatte 2 mit den Abstandshaltern 16, 17 erfolgt im gleichen Arbeitsgang wie die Bestückung der Frontplatte 2 mit der Auswerteelektronik 4. Zudem sind bei dieser Ausführungsform die auf beiden Seiten 8 und 9 angeordneten Leitstrukturen 10, 11 sowie die elektrisch leitfähigen Schichten 12, 13 über zwei Federkontakte 20 und 21, die hier als Metallklammern ausgebildet sind, und eine elektrische Leitungsstruktur 19 auf der Frontplatte 2 mit der Auswerteelektronik 4 verbunden. Ansonsten haben gleiche Bezugszeichen die gleiche Bedeutung wie in Fig. 1.

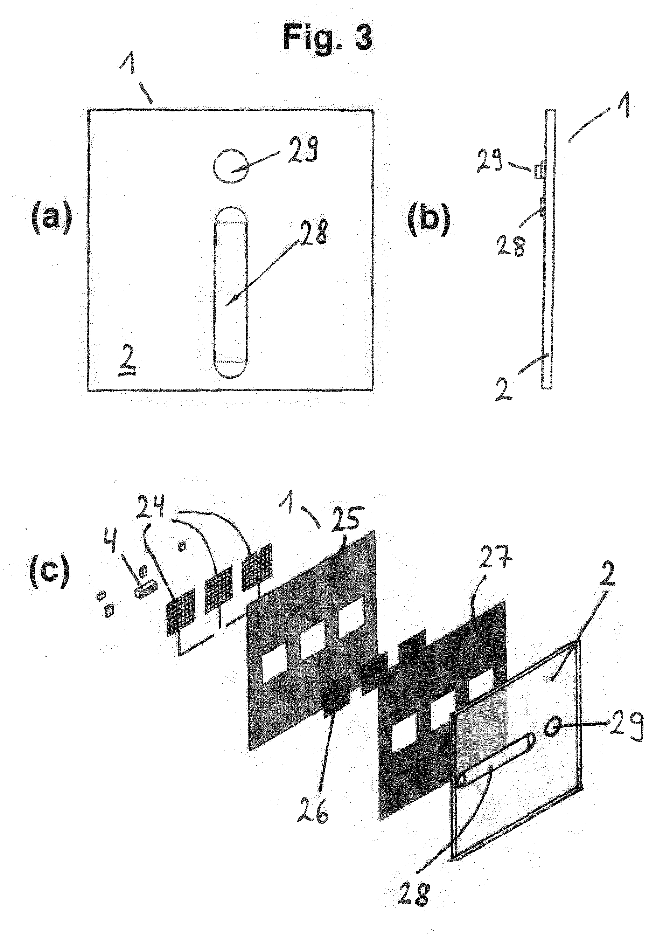

Fig. 3 zeigt eine dritte Ausführungsform einer erfindungsgemäßen kapazitiven Bedieneinheit. (a) ist eine Draufsicht auf die Bedieneinheit, (b) ist eine Seitenansicht auf die Bedieneinheit und (c) eine Explosionsansicht der Bedieneinheit.

In Fig. 3 (a) ist schematisch eine Draufsicht auf eine Bedieneinheit 1 einer dritten Ausführungsform dargestellt. Auf einer Frontplatte 2 aus Glas sind hier ein länglicher Slider 28 sowie eine runde Sensortaste 29 als beispielhafte Bedienelemente gezeigt. In der Seitenansicht der Fig. 3 (b) ist erkennbar, dass diese Bedienelemente unterschiedlich stark aus der Ebene der Frontplatte 2 herausragen. Dabei ragt die Sensortaste 29 mehr aus der Ebene der Frontplatte 2 heraus als der Slider 28. Eine Person, die sich im Wasser befindet, kann daher leicht durch Ertasten der Oberfläche der Bedieneinheit 1 erkennen, ob sie gerade den Slider 28 oder die Sensortaste 29 vor sich hat. Damit ist für eine im Wasser befindliche Person eine Bedienung der Bedieneinheit 1 auch bei einer ggf. schlechten optischen Erkennbarkeit der Bedieneinheit sicher und bequem möglich. Die Bedienelemente können dabei prinzipiell sehr unterschiedliche Oberflächenstrukturen aufweisen, die geschliffen oder auch - wie hier gezeigt - erhaben abgebildet werden können. Außerdem können die Bedienelemente zur Unterscheidung auch unterschiedliche Oberflächenrauigkeiten aufweisen.

Fig. 3 (c) zeigt eine Explosionsansicht der Bedieneinheit 1. Auf der Frontplatte 2 aus Glas sind der Slider 28 sowie die Sensortaste 29 aus Fig. 3 (a) bzw. (b) angeordnet. In Richtung des Inneren der Bedieneinheit 1 sind dann in der angegebenen Reihenfolge ein Designdruck 27, ein Lasurdruck 26 sowie ein Sperrdruck 25 gezeigt. Dahinter befindet sich ein sog. Leiterbahndruck 24, welcher Leiterbahnen und kapazitive Sensorelektroden aufweist. 4 steht für die Auswerteelektronik, welche hier anhand einzelner kleiner Bauelemente dargestellt ist.

### Bezugszeichenliste

- 1: Kapazitive Bedieneinheit zur Anwendung unter Wasser
- 2: Frontplatte aus Glas
- 3: Erste Oberfläche der Frontplatte
- 4: Auswerteelektronik
- 5: Im Wesentlichen transparenter Bereich der Frontplatte
- 6: Nicht-transparenter Bereich der Frontplatte
- 7: Sensorplatte aus Dünnglas
- 8: Erste Oberfläche der Sensorplatte, der Frontplatte zugewandt
- 9: Zweite Oberfläche der Sensorplatte, der Frontplatte abgewandt
- 10,11: keramische Leitstrukturen aus eingebrannter keramischer Leitpaste
- 12,13: strukturierte im Wesentlichen transparente, elektrisch leitfähige Schicht
- 14: Flex-Kabel
- 15: Klebeschicht
- 16,17: Abstandshalter
- 18: Zwischenraum
- 19: elektrische Leitungsstruktur auf Frontplatte
- 20, 21: Federkontakte
- 22: Wasser; wässrige Flüssigkeit
- 23: Behälterwand, in welche die Bedieneinheit integriert ist
- 24: Leiterbahnen, Sensorelektroden; Leiterbahndruck
- 25: Sperrdruck
- 26: Lasurdruck
- 27: Designdruck
- 28: Slider
- 29: Sensortaste

## Patentansprüche

1. Bedieneinheit (1) für einen Einsatz unter Wasser, mit einer Frontplatte (2) aus Glas und elektrischen Sensorelementen, die auf einer Auswertung von Änderungen der elektrischen Kapazität basieren, und einer Steuerungseinheit, wobei die Sensorelemente auf einer einem Inneren der Bedieneinheit (1) zugewandten ersten Oberfläche (3) der Frontplatte (2) und/oder auf einer Sensorplatte (7) platziert sind, wobei auf der Frontplatte (2) und/oder der Sensorplatte (7), auf der Sensorelemente platziert sind, eine keramische Leitstruktur (10,11) aus einer eingebrannten keramischen Leitpaste angeordnet ist; wobei ein Sensorelement durch eine strukturierte elektrisch leitfähige Beschichtung (12,13) gebildet wird, wobei die strukturierte elektrisch leitfähige Beschichtung (12,13) mit der keramischen Leitstruktur (10,11) elektrisch leitfähig verbunden ist, und wobei die Bedieneinheit (1) mindestens zwei Sensorelemente umfasst, die unabhängig voneinander als Sensortaste (29) oder Slider (28) ausgestaltet sind, die mit einem Mikrocontroller verbunden sind, wobei Sensortaste und/oder Slider auf eine Berührung oder Annäherung durch einen Menschen an die Bedieneinheit (1) mit einer Änderung einer Kapazität reagieren und die Steuerungseinheit ausgestaltet ist, um aus dem Ausmaß der Änderung der Kapazität sowie deren zeitlicher Änderung bei mindestens zwei Sensorelementen auf eine Berührung oder Annäherung eines Menschen zu schließen und außerdem zu erkennen, ob sich die kapazitive Bedieneinheit (1) im Kontakt mit Wasser oder außerhalb von Wasser befindet, und als Reaktion auf die Berührung oder Annäherung eine Aktion auszulösen, wenn sich die Bedieneinheit (1) unter Wasser befindet, und wobei die Bedieneinheit (1) ein IR-Sensorsystem und/oder einen Helligkeitssensor umfasst , so dass sowohl durch ein kapazitives als auch durch ein optisches Verfahren hinsichtlich einer Betätigung ausgewertet wird.

2. Bedieneinheit (1) nach Anspruch 1, **dadurch gekennzeichnet, dass** die auf der Frontplatte (2) und/oder einer Sensorplatte (7) angeordnete strukturierte elektrisch leitfähige Schicht (12,13) im Wesentlichen transparent ist.

3. Bedieneinheit (1) nach einem der Ansprüche 1 bis 2, **dadurch gekennzeichnet, dass** die eingebrannte keramische Leitpaste mindestens 50 Gew.-% Silber enthält.

4. Bedieneinheit (1) nach einem der Ansprüche 1 bis 3, **dadurch gekennzeichnet, dass** mindestens ein Bedienelement auf einer äußeren Oberfläche der Frontplatte (2) angeordnet ist, wobei das mindestens eine Bedienelement (28,29) an einer Stelle der Frontplatte (2) angeordnet ist, die der Sensortaste (29) oder dem Slider (28) entspricht, und wobei das mindestens eine Bedienelement (28,29) aus der Ebene der Frontplatte (2) herausragt, so dass es sich haptisch von der Umgebung dieser Stelle unterscheidet.

5. Bedieneinheit (1) nach einem der Ansprüche 1 bis 4, **dadurch gekennzeichnet, dass** auf beiden Seiten der Sensorplatte (7) jeweils mindestens eine keramische Leitstruktur (10,11) angeordnet ist.

6. Bedieneinheit (1) nach einem der Ansprüche 1 bis 5, **dadurch gekennzeichnet, dass** die Frontplatte (2) eine Dicke im Bereich von 1 mm bis 10 mm hat.

7. Bedieneinheit (1) nach einem der Ansprüche 1 bis 6, **dadurch gekennzeichnet, dass** sie eine Sensorplatte (7) aus Glas mit einer Dicke im Bereich von 0,2 bis 2,0 mm aufweist.

8. Bedieneinheit (1) nach Anspruch 7, **dadurch gekennzeichnet, dass** zwischen Frontplatte (2) und Sensorplatte (7) mindestens ein Abstandshalter (16,17) angeordnet ist und eine auf der Sensorplatte (7) gebildete keramische Leitstruktur (10,11) der Sensorplatte (7) über mindestens einen Federkontakt (20,21) kontaktiert ist.

9. Bedieneinheit (1) nach einem der Ansprüche 1 bis 8, **dadurch gekennzeichnet, dass** auf einer dem Inneren der Bedieneinheit (1) zugewandten ersten Oberfläche (3) der Frontplatte (2), die mindestens teilweise mit mindestens einer lichtundurchlässigen Schicht beschichtet ist, ein Gehäuse angeordnet ist, dessen innere Oberfläche mindestens teilweise Lichtstrahlen reflektieren kann; und mindestens ein in einem Raum zwischen dem Gehäuse und der ersten Oberfläche (3) der Frontplatte (2) angeordnetes Leuchtmittel, wobei vom Leuchtmittel erzeugte Lichtstrahlen mindestens teilweise in die Frontplatte (2) gelangen können.

10. Verfahren zur Herstellung einer Bedieneinheit (1) für einen Einsatz unter Wasser, mit einer Frontplatte (2) aus Glas und elektrischen Sensorelementen, die auf einer Auswertung von Änderungen der elektrischen Kapazität basieren, und einer Steuerungseinheit, wobei die Sensorelemente auf einer einem Inneren der Bedieneinheit (1) zugewandten ersten Oberfläche (3) der Frontplatte (2) und/oder auf einer Sensorplatte (7) platziert sind, wobei auf der Frontplatte (2) und/oder der Sensorplatte (7), auf der Sensorelemente platziert sind, eine keramische Leitstruktur (10,11) aus einer eingebrannten keramischen Leitpaste angeordnet ist; wobei ein Sensorelement durch eine strukturierte elektrisch leitfähige Beschichtung (12,13) gebildet wird, wobei die strukturierte elektrisch leitfähige Beschichtung (12,13) mit der keramischen Leitstruktur (10,11) elektrisch leitfähig verbunden ist, und wobei die Bedieneinheit (1) mindestens zwei Sensorelemente umfasst, die unabhängig voneinander als Sensortaste (29) oder Slider (28) ausgestaltet sind, die mit einem Mikrocontroller verbunden sind, wobei Sensortaste (29) und/oder Slider (28) auf eine Berührung oder Annäherung durch einen Menschen an die Bedieneinheit (1) mit einer Änderung einer Kapazität reagieren und die Steuerungseinheit ausgestaltet ist, um aus dem Ausmaß der Änderung der Kapazität sowie deren zeitlicher Änderung bei mindestens zwei Sensorelementen auf eine Berührung oder Annäherung eines Menschen zu schließen und außerdem zu erkennen, ob sich die kapazitive Bedieneinheit (1) im Kontakt mit Wasser oder außerhalb von Wasser befindet, und als Reaktion auf die Berührung oder Annäherung eine Aktion auszulösen, wenn sich die Bedieneinheit (1) unter Wasser befindet, und wobei die Bedieneinheit (1) ein IR-Sensorsystem und/oder einen Helligkeitssensor umfasst, so dass sowohl durch ein kapazitives als auch durch ein optisches Verfahren hinsichtlich einer Betätigung ausgewertet wird, wobei es die folgenden Schritte umfasst:
(ii) Aufbringen einer einbrennbaren keramischen Leitpaste auf die Frontplatte (2) und/oder die Sensorplatte (7) und
(iv) Einbrennen der keramischen Leitpaste.

11. Verfahren nach Anspruch 10, **dadurch gekennzeichnet, dass** die Einbrenntemperatur in Schritt (iv) im Bereich von 500 bis 700°C liegt.

## Claims

1. Operating unit (1) for use under water, with a front panel (2) made of glass and electrical sensor elements based on an evaluation of changes in electrical capacitance, and a control unit, wherein the sensor elements are placed on a first surface (3) of the front panel (2) facing an interior of the control unit (1) and/or on a sensor plate (7), wherein a ceramic conductive structure (10, 11) made of a baked-on ceramic conductive paste is arranged on the front panel (2) and/or the sensor plate (7) on which sensor elements are placed; wherein a sensor element is formed by a structured electrically conductive coating (12, 13), wherein the structured electrically conductive coating (12, 13) is electrically conductively connected to the ceramic conductive structure (10, 11), and wherein the operating unit (1) comprises at least two sensor elements which are configured independently of one another as a sensor key (29) or slider (28), which are connected to a microcontroller, wherein the sensor key and/or slider react to a touch or approach by a human to the operating unit (1) with a change in a capacitance, and the control unit is configured to infer from the extent of the change in capacitance as well as its change over time in at least two sensor elements that a human has touched or approached the capacitive operating unit (1) and also to detect whether the capacitive operating unit (1) is in contact with water or outside water and to trigger an action in response to the touch or approach when the operating unit (1) is under water, and wherein the operating unit (1) comprises an IR sensor system and/or a brightness sensor, so that evaluation is carried out by both a capacitive and an optical method with regard to an actuation.

2. Operating unit (1) according to claim 1, **characterized in that** the structured electrically conductive layer (12, 13) arranged on the front panel (2) and/or a sensor panel (7) is essentially transparent.

3. Operating unit (1) according to one of claims 1 to 2, **characterized in that** the baked-on ceramic conductive paste contains at least 50% by weight of silver.

4. Operating unit (1) according to one of claims 1 to 3, **characterized in that** at least one operating element is arranged on an outer surface of the front panel (2), the at least one operating element (28, 29) being arranged at a location on the front panel (2) which corresponds to the sensor key (29) or the slider (28), and the at least one operating element (28, 29) projecting out of the plane of the front panel (2) so that it differs haptically from the surroundings of this location.

5. Operating unit (1) according to one of claims 1 to 4, **characterized in that** at least one ceramic conductive structure (10, 11) is arranged on each of the two sides of the sensor plate (7).

6. Operating unit (1) according to one of claims 1 to 5, **characterized in that** the front panel (2) has a thickness in the range from 1 mm to 10 mm.

7. Operating unit (1) according to one of claims 1 to 6, **characterized in that** it has a sensor plate (7) made of glass with a thickness in the range from 0.2 to 2.0 mm.

8. Operating unit (1) according to claim 7, **characterized in that** at least one spacer (16, 17) is arranged between the front panel (2) and the sensor plate (7), and a ceramic conductive structure (10, 11) of the sensor plate (7) formed on the sensor plate (7) is contacted via at least one spring contact (20, 21).

9. Operating unit (1) according to one of claims 1 to 8, **characterized in that** on a first surface (3) of the front panel (2) facing the interior of the operating unit (1), which is at least partially coated with at least one opaque layer, a housing is arranged, the inner surface of which can at least partially reflect light rays; and at least one illuminant arranged in a space between the housing and the first surface (3) of the front panel (2), wherein light rays generated by the illuminant can at least partially enter the front panel (2).

10. Process for manufacturing a control unit (1) for use under water, with a front panel (2) made of glass and electrical sensor elements based on an evaluation of changes in electrical capacitance, and a control unit, wherein the sensor elements are placed on a first surface (3) of the front panel (2) facing an interior of the control unit (1) and/or on a sensor plate (7), wherein a ceramic conductive structure (10, 11) made of a baked-on ceramic conductive paste is arranged on the front panel (2) and/or the sensor plate (7) on which sensor elements are placed; wherein a sensor element is formed by a structured electrically conductive coating (12, 13), wherein the structured electrically conductive coating (12, 13) is electrically conductively connected to the ceramic conductive structure (10, 11), and wherein the operating unit (1) comprises at least two sensor elements which are configured independently of one another as a sensor key (29) or slider (28), which are connected to a microcontroller, wherein the sensor key (29) and/or slider (28) react to a touch or approach by a human to the operating unit (1) with a change in a capacitance, and the control unit is configured to infer from the extent of the change in capacitance as well as its change over time in at least two sensor elements that a human has touched or approached the operating unit (1) and also to detect whether the capacitive operating unit (1) is in contact with water or outside water and to trigger an action in response to the touching or approaching, when the control unit (1) is under water, and wherein the control unit (1) comprises an IR sensor system and/or a brightness sensor so as to be evaluated by both a capacitive and an optical method with respect to an actuation, comprising the steps of:
(ii) applying a bakeable ceramic conductive paste to the front panel (2) and/or the sensor panel (7); and
(iv) baking the ceramic conductive paste.

11. Process according to claim 10, **characterized in that** the baking temperature in step (iv) is in the range of 500 to 700°C.

## Revendications

1. Unité de commande (1) pour une utilisation sous l'eau, avec une plaque frontale (2) en verre et des éléments de détection électriques, qui sont basés sur une évaluation des modifications de la capacité électrique, et une unité de commande, les éléments de détection étant placés sur une première surface (3) de la plaque frontale (2) tournée vers l'intérieur de l'unité de commande (1) et/ou sur une plaque de détection (7), une structure conductrice céramique (10, 11) constituée d'une pâte conductrice céramique cuite étant disposée sur la plaque frontale (2) et/ou la plaque de détection (7) sur laquelle sont placés les éléments de détection ; un élément de détection étant formé par un revêtement structuré électriquement conducteur (12, 13), le revêtement structuré électriquement conducteur (12, 13) étant relié de manière électriquement conductrice à la structure conductrice en céramique (10, 11), et l'unité de commande (1) comprenant au moins deux éléments de détection, qui sont conçus indépendamment l'un de l'autre comme une touche de capteur (29) ou un curseur (28), qui sont reliés à un microcontrôleur, la touche de capteur et/ou le curseur réagissant à un contact ou à un rapprochement par un être humain de l'unité de commande (1) avec une modification d'une capacité et l'unité de commande étant conçue, pour déduire, à partir de l'ampleur de la modification de la capacité ainsi que de sa modification dans le temps pour au moins deux éléments de détection, un contact ou une approche d'un être humain et pour reconnaître en outre si l'unité de commande capacitive (1) se trouve en contact avec l'eau ou hors de l'eau, et de déclencher une action en réaction au contact ou à l'approche lorsque l'unité de commande (1) se trouve sous l'eau, et dans lequel l'unité de commande (1) comprend un système de capteurs IR et/ou un capteur de luminosité, de sorte qu'un actionnement est évalué à la fois par un procédé capacitif et par un procédé optique.

2. Unité de commande (1) selon la revendication 1, **caractérisée en ce que** la couche électriquement conductrice structurée (12, 13) disposée sur la plaque frontale (2) et/ou sur une plaque de détection (7) est essentiellement transparente.

3. Unité de commande (1) selon l'une des revendications 1 à 2, **caractérisée en ce que** la pâte conductrice céramique cuite contient au moins 50 % en poids d'argent.

4. Unité de commande (1) selon l'une des revendications 1 à 3, **caractérisée en ce qu'**au moins un élément de commande est disposé sur une surface extérieure de la plaque frontale (2), ledit au moins un élément de commande (28, 29) étant disposé à un endroit de la plaque frontale (2) qui correspond à la touche de capteur (29) ou au curseur (28), et ledit au moins un élément de commande (28, 29) dépassant du plan de la plaque frontale (2) de sorte qu'il se distingue haptiquement de l'environnement de cet endroit.

5. Unité de commande (1) selon l'une des revendications 1 à 4, **caractérisée en ce qu'**au moins une structure conductrice en céramique (10, 11) est disposée sur chacun des deux côtés de la plaque de détection (7).

6. Unité de commande (1) selon l'une des revendications 1 à 5, **caractérisée en ce que** la plaque frontale (2) a une épaisseur comprise entre 1 mm et 10 mm.

7. Unité de commande (1) selon l'une des revendications 1 à 6, **caractérisée en ce qu'**elle comprend une plaque de détection (7) en verre ayant une épaisseur comprise entre 0,2 et 2,0 mm.

8. Unité de commande (1) selon la revendication 7, **caractérisée en ce qu'**au moins une entretoise (16, 17) est disposée entre la plaque frontale (2) et la plaque de détection (7) et qu'une structure conductrice céramique (10, 11) de la plaque de détection (7) formée sur la plaque de détection (7) est mise en contact par au moins un contact à ressort (20, 21).

9. Unité de commande (1) selon l'une des revendications 1 à 8, **caractérisée en ce que** sur une première surface (3) de la plaque frontale (2) tournée vers l'intérieur de l'unité de commande (1), qui est au moins partiellement revêtue d'au moins une couche opaque, est disposé un boîtier dont la surface intérieure peut réfléchir au moins partiellement des rayons lumineux ; et au moins un moyen d'éclairage disposé dans un espace entre le boîtier et la première surface (3) de la plaque frontale (2), des rayons lumineux générés par le moyen d'éclairage pouvant parvenir au moins partiellement dans la plaque frontale (2).

10. Procédé de fabrication d'une unité de commande (1) pour une utilisation sous l'eau, avec une plaque frontale (2) en verre et des éléments de détection électriques qui sont basés sur une évaluation des modifications de la capacité électrique, et une unité de commande, les éléments de détection étant placés sur une première surface (3) de la plaque frontale (2) tournée vers l'intérieur de l'unité de commande (1) et/ou sur une plaque de détection (7), une structure conductrice céramique (10, 11) constituée d'une pâte conductrice céramique cuite étant disposée sur la plaque frontale (2) et/ou la plaque de détection (7) sur laquelle sont placés les éléments de détection ; un élément de détection étant formé par un revêtement structuré électriquement conducteur (12, 13), le revêtement structuré électriquement conducteur (12, 13) étant relié de manière électriquement conductrice à la structure conductrice en céramique (10, 11), et l'unité de commande (1) comprenant au moins deux éléments de détection, qui sont conçus indépendamment l'un de l'autre comme une touche de capteur (29) ou un curseur (28), qui sont reliés à un microcontrôleur, la touche de capteur (29) et/ou le curseur (28) réagissant à un contact ou à un rapprochement par un être humain de l'unité de commande (1) avec une modification d'une capacité et l'unité de commande étant conçue, pour conclure, à partir de l'ampleur de la modification de la capacité ainsi que de sa modification dans le temps pour au moins deux éléments de détection, à un contact ou à une approche d'un être humain et pour reconnaître en outre si l'unité de commande capacitive (1) se trouve en contact avec l'eau ou hors de l'eau, et pour déclencher une action en réaction au contact ou à l'approche, lorsque l'unité de commande (1) est sous l'eau, et dans lequel l'unité de commande (1) comprend un système de capteur IR et/ou un capteur de luminosité, de sorte qu'il est évalué à la fois par un procédé capacitif et par un procédé optique en ce qui concerne une action, comprenant les étapes suivantes:
(ii) appliquer une pâte conductrice céramique pouvant être cuite sur la plaque frontale (2) et/ou la plaque de détection (7), et
(iv) cuisson de la pâte conductrice céramique.

11. Procédé selon la revendication 10, **caractérisé en ce que** la température de cuisson à l'étape (iv) est comprise entre 500 et 700°C.
